# EUROPEAN PATENT APPLICATION

(11) **EP 2 223 949 A1**
(43) Date of publication of application: **01.09.2010**
(21) Application number: 08859768.7
(22) Date of filing: 02.12.2008
(51) Int. Cl.: C08G 61/02, C09K 11/06, H01L 51/50

(54) **POLYMER COMPOUND AND ORGANIC ELECTROLUMINESCENT DEVICE USING THE SAME**

(30) Priority: 11.12.2007 JP 2007319799
(71) Applicant: Idemitsu Kosan Co., Ltd., Chiyoda-ku Tokyo 100-8321 (JP)
(72) Inventor: ITO, Mitsunori, Sodegaura-shi Chiba 299-0293 (JP); MIZUKI, Yumiko, Sodegaura-shi Chiba 299-0293 (JP)
(74) Representative: Vossius & Partner
(86) International application number: PCT/JP2008/071889
(87) International publication number: WO 2009/075203

(57) **Abstract**

A polymer comprising a repeating unit derived from a compound represented by formula (1): 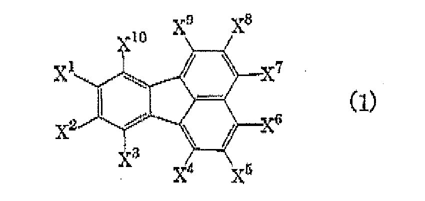 wherein X¹ to X¹⁰ are as defined in the specification and a repeating unit derived from an aromatic compound having a specific structure. The polymer is useful as a light emission material and realizes a polymer electroluminescence device excellent in device characteristics such as lifetime and emission efficiency.

## Description

### TECHNICAL FIELD

The present invention relates to a polymer comprising a repeating unit which functions as dopant and a repeating unit which functions as host and further relates to an organic electroluminescence device (organic EL device) employing the polymer.

### BACKGROUND ART

Polymeric electroluminescence materials are widely studied because of their advantage that they are made into films by applying or printing their solution. For example, polymers comprising an aromatic unit having a diarylamino group and a unit having a structure such as fluorene, dibenzofuran, and dibenzothiophene are reported (Patent Documents 1 and 2). However, a light emission device employing the above polymers is not necessarily sufficient in the device characteristics such as lifetime (half lifetime) and emission efficiency.

Patent Document 1: JP 2007-162009A
Patent Document 2: WO 2005/049546

### DISCLOSURE OF THE INVENTION

An object of the invention is to provide a polymer which is useful as a light emission material and realizes a polymer EL device excellent in device characteristics such as lifetime and emission efficiency.

Thus, the present invention provides a polymer comprising a repeating unit A and a repeating unit B,
wherein the repeating unit A is selected from divalent groups which are derived from compounds represented by formula, (1): 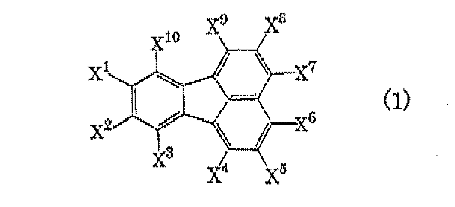 wherein X¹ to X¹⁰ are each independently hydrogen atom, a halogen atom, an alkyl group halving 1 to 30 carbon atoms, a cycloalkyl group having 3 to 30 ring-forming carbon atoms, an alkoxy group having 1 to 30 carbon atoms, a cycloalkyloxy group having 3 to 30 ring-forming carbon atoms, an alkylthio group having 1 to 30 carbon atoms, a cycloalkylthio group having 3 to 30 ring-forming carbon atoms, an alkenyl group having 2 to 30 carbon atoms, a cycloalkenyl group having 3 to 30 ring-forming carbon atoms, an alkenyloxy group having 2 to 30 carbon atoms, a cycloalkenyloxy group having 3 to 30 ring-forming carbon atoms, an alkenylthio group having 2 to 30 carbon atoms, a cycloalkenylthio group having 3 to 30 ring-forming carbon atoms, an aralkyl group having 7 to 30 carbon atoms, an aralkyloxy group having 7 to 30 carbon atoms, an aralkylthio group having 7 to 30 carbon atoms, an aryl group having 6 to 20 ring-forming carbon atoms, a heterocyclic group having 5 to 20 ring-forming carbon atoms, an aryloxy group having 6 to 20 ring-forming carbon atoms, an arylthio group having 6 to 20 ring-forming carbon atoms, a mono- or disubstituted amino group having 1 to 30 carbon atoms, cyano group, silyl group, hydroxyl group, -COOR¹⁰ wherein R¹⁰ is hydrogen atom, an alkyl group having 1 to 30 carbon atoms, a cycloalkyl group having 3 to 30 ring-forming carbon atoms, an alkenyl group having 2 to 30 carbon atoms, a cycloalkenyl group having 3 to 30 ring-forming carbon atoms, an aralkyl group having 7 to 30 carbon atoms, or an aryl group having 6 to 30 ring-forming carbon atoms, -COR¹¹ wherein R¹¹ is hydrogen atom, an alkyl group having 1 to 30 carbon atoms, a cycloalkyl group having 3 to 30 ring-formting carbon atoms, an alkenyl group having 2 to 30 carbon atoms, a cycloalkenyl group having 3 to 30 ring-forming carbon atoms, an aralkyl group having 7 to 30 carbon atoms, an aryl group having 6 to 30 ring-forming carbon atoms, or amino group, or -OCOR¹² wherein R¹² is an alkyl group having 1 to 30 carbon atoms, a cycloalkyl group having 3 to 30 ring-forming carbon atoms, an alkenyl group having 2 to 30 carbon atoms, a cycloalkenyl group having 3 to 30 ring-forming carbon atoms, an aralkyl group having 7 to 30 carbon atoms, or an aryl group having 6 to 30 ring-forming carbon atoms, each of the above groups being optionally substituted, if applicable, and adjacent groups of X¹ to X¹⁰ and substituents on adjacent groups of X¹ to X¹⁰ being optionally bonded to each other to form a divalent group which completes a substituted or unsubstituted ring;
the repeating unit B is selected from divalent groups which are derived from compounds represented by any one of formulae (2) to (9): 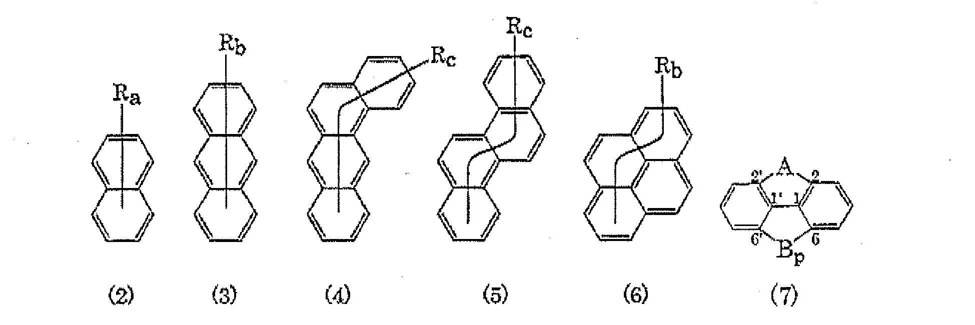 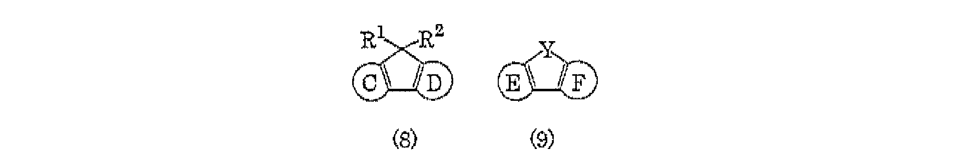 wherein, in formulae (2) to (6), R is a substituted or unsubstituted aryl group having 6 to 40 ring-forming carbon atoms, a substituted or unsubstituted heterocyclic group having 3 to 40 ring-forming atoms, or a substituted or unsubstituted alkyl group having 1 to 50 carbon atoms; a is an integer or 0 to 8; b is an integer of 0 to 10; and c is an integer of 0 to 12;
in formula (7), A is a substituted or unsubstituted divalent saturated group which forms a 5- to 8-membered ring together with the carbon atoms at 1, 2, 1', and 2' positions of the biphenyl structure; B is a substituted or unsubstituted divalent saturated group which forms a 5- to 8-membered ring together with the carbon atoms at 1, 6, 1', and 6' positions of the biphenyl structure; A and B may be the same or different; p is 0 or 1 and no bond is formed between the carbon atoms at 5 and 6 positions when p is 0; and a ring structure formed by A and the carbon atoms at 1, 2, 1', and 2' positions and/or a ring structure formed by B and the carbon atoms at 1, 6, 1', and 6' positions may have a spiro-ring structure;
in formula (8), a ring C and a ring D are each independently an aromatic hydrocarbon ring having 6 to 40 ring-forming carbon atoms; at least one of the ring C and the ring D is an aromatic hydrocarbon ring comprising two or more condensed benzene rings; R¹ and R² are each independently hydrogen atom, an alkyl group having 1 to 30 carbon atoms, an alkoxy group having 1 to 30 carbon atoms, an alkylthio group having 1 to 30 carbon atoms, an aryl group having 6 to 20 ring-forming carbon atoms, an aryloxy group having 6 to 20 ring-forming carbon atoms, an arylthio group having 6 to 20 ring-forming carbon atoms, an aralkyl group having 7 to 30 carbon atoms, an aralkyloxy group having 7 to 30 carbon atoms, an aralkylthio group having 7 to 30 carbon atoms, an arylalkenyl group having 8 to 30 carbon atoms, an arylalkynyl group having 8 to 30 carbon, atoms, amino group, a mono- or disubstituted amino group having 1 to 30 carbon atoms, silyl group, a mono-, di- or trisubstituted silyl group having 1 to 30 carbon atoms, a halogen atom, -COR¹¹ wherein R¹¹ is as defined above, -OCOR¹² wherein R¹² is as defined above, an imine residue having 2 to 30 carbon atoms, an amido group having 2 to 30 carbon atoms, an acid imido group having 3 to 30 carbon atoms, a heterocyclic group having 5 to 20 ring-forming carbon atoms, -COOR¹⁰ wherein R¹⁰ is as defined above, nitro group, or cyano group, and R¹ and R² may be bonded to each other to form a ring; and
in formula (9), a ring E and a ring F are each independently an aromatic hydrocarbon ring having 6 to 40 ring-forming carbon atoms; Y is oxygen atom, sulfur atom, or -O-C(R₃)₂- wherein two R³ groups are each independently hydrogen atom, an alkyl group having 1 to 30 carbon atoms, an alkoxy group having 1 to 30 carbon atoms, an alkylthio group halving 1 to 30 carbon atoms, an aryl group having 6 to 20 ring-forming carbon atoms, an aryloxy group having 6 to 20 ring-forming carbon atoms, an arylthio group having 6 to 20 ring-forming carbon atoms, an aralkyl group having 7 to 30 carbon atoms, an aralkyloxy group having 7 to 30 carbon atoms, an aralkylthio group having 7 to 30 carbon atoms, an arylalkenyl group having 8 to 30 carbon atoms, an arylalkynyl group having 8 to 30 carbon atoms, amino group, a mono- or disubstituted amino group having 1 to 30 carbon atoms, silyl group, a mono-, di- or trisubstituted silyl group having 1 to 30 carbon atoms, halogen atom, -COR¹¹ wherein R¹¹ is as defined above, -OCOR¹² wherein R¹² is as defined above, an imine residue having 2 to 30 carbon atoms, an amido group having 2 to 30 carbon atoms, an acid imido group having 3 to 30 carbon atoms, a heterocyclic group having 5 to 20 ring-forming carbon atoms, -COOR¹⁰ wherein R¹⁰ is as defined above, nitro group, or cyano group, and two R³ croup may be the same or different.

The present invention further provides an organic electroluminescence device comprising an anode, a cathode, and an organic compound layer which comprises a layer and is disposed between the anode and the cathode, wherein at least one layer of the organic compound layer is a light-emitting layer comprising a polymer mentioned above.

The polymer of the invention is useful as the light emission material and provides an organic EL device excellent in the performance such as lifetime and emission efficiency.

### BEST MODE FOR CARRYING OUT THE INVENTION

The polymer of the invention comprises a repeating unit A selected from the divalent groups derived from the compounds of formula (1):

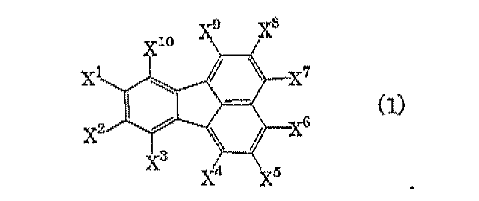

In formula (1), X¹ to X¹⁰ are each independently hydrogen atom, a halogen atom, an alkyl group having 1 to 30 carbon atoms, a cycloalkyl group having 3 to 30 ring-forming carbon atoms, an alkoxy group having 1 to 30 carbon atoms, a cycloalkyloxy group having 3 to 30 ring-forming carbon atoms, an alkylthio group, having 1 to 30 carbon atoms, a cycloalkylthio group having 3 to 30 ring-forming carbon atoms, an alkenyl group having 2 to 30 carbon atoms, a cycloalkenyl group having 3 to 30 ring-forming carbon atoms, an alkenyloxy group having 2 to 30 carbon atoms, a cycloalkenyloxy group having 3 to 30 ring-forming carbon atoms, an alkenylthio group having 2 to 30 carbon atoms, a cycloalkenylthio group having 3 to 30 ring-forming carbon atoms, an aralkyl group having 7 to 30 carbon atoms, an aralkyloxy group having 7 to 30 carbon atoms, an aralkylthio group having 7 to 30 carbon atoms, an aryl group having 6 to 20 ring-forming carbon atoms, a heterocyclic group having 5 to 20 ring-forming carbon atoms, an aryloxy group having 6 to 20 ring-forming carbon atoms, an arylthio group having 6 to 20 ring-forming carbon atoms, a mono- or disubstituted amino group having 1 to 30 carbon atoms, cyano group, silyl group, hydroxyl group, -COOR¹⁰ wherein R¹⁰ is hydrogen atom, an alkyl group having 1 to 30 carbon atoms, a cycloalkyl group having 3 to 30 ring-forming carbon atoms, an alkenyl group having 2 to 30 carbon atoms, a cycloalkenyl group having 3 to 30 ring-forming carbon atoms, an aralkyl group having 7 to 30 carbon atoms, or an aryl group having 6 to 30 ring-forming carbon atoms, -COR¹¹ wherein R¹¹ is hydrogen atom, an alkyl group having 1 to 30 carbon atoms, a cycloalkyl group having 3 to 30 ring-forming carbon atoms, an alkenyl group having 2 to 30 carbon atoms, a cycloalkenyl group having 3 to 30 ring-forming carbon atoms, an aralkyl group having 7 to 30 carbon atoms, an aryl group having 6 to 30 ring-forming carbon atoms, or amino group, or -OCOR¹² wherein R¹² is an alkyl group having 1 to 80 carbon atoms, a cycloalkyl group having 3 to 30 ring-forming carbon atoms, an alkenyl group having 2 to 30 carbon atoms, a cycloalkenyl group having 3 to 30 ring-forming carbon atoms, an aralkyl group having 7 to 30 carbon atoms, or an aryl group having 6 to 30 ring-forming carbon atoms.
Preferably, X¹ and X¹⁰ are each independently hydrogen atom, an alkyl group having 1 to 30 carbon atoms, a cycloalkyl group having 3 to 30 ring-forming carbon atoms, an alkoxy group having 1 to 30 carbon atoms, an alkenyl group having 2 to 30 carbon atoms, an aryl group having 6 to 20 ring-forming carbon atoms, a heterocyclic group having 5 to 20 ring-forming carbon atoms, cyano group, or silyl group.

Each group for X¹ to X¹⁰ may be substituted, if applicable. The adjacent pair of groups of X¹ to X¹⁰ and the substituents on the adjacent pair of groups of X¹ to X¹⁰ may be bonded to each other, respectively, to form a divalent group which completes a substituted or unsubstituted ring.

Examples of the halogen atom for X¹ to X¹⁰ include fluorine atom, chlorine atom, bromine atom and iodine atoms.

The substituted or unsubstituted alkyl group having 1 to 30 carbon atoms for X¹ to X¹⁰ may be linear or branched, and examples thereof include methyl group, ethyl group, propyl group, isopropyl group, n-butyl group, s-butyl group, isobutyl group, t-butyl group, n-pentyl group, n-hexyl group, n-heptyl groups, n-octyl group n-nonyl group, n-decyl group, n-undecyl group, n-dodecyl group, n-tridecyl group, n-tetradecyl group, n-pentadecyl group, n-hexadecyl group, n-heptadecyl group, n-octadecyl group, neopentyl group, 1-methylpentyl group, 2-methylpentyl group, 1-pentylhexyl group, 1-butylpentyl group, 1-heptyloctyl group, 3-methylpentyl group, hydroxymethyl group, 1-hydroxyethyl group, 2-hydroxyethyl group, 2-hydroxyisobutyl group, 1,2-dihydroxyethyl group, 1,3-dihydroxyisopropyl group, 2,3-dihydroxy-t-butyl group, 1,2,3-trihydxoxypropyl group, chloromethyl group, 1-chloroethyl group, 2-chloroethyl group, 2-chloroisobutyl group, 1,2-dichloroethyl group, 1,3-dichloroisopropyl group, 2,3-dichloro-t-butyl group, 1,2,3-trichloropropyl group, bromomethyl group, 1-bromoethyl group, 2-bromoethyl group, 2-bromoisobutyl group, 1,2-dibromoethyl group, 1,3-dibromoisopropyl group, 2,3-dibromo-t-butyl group, 1,2,3-tribromopropyl group, iodomethyl group, 1-iodoethyl group, 2-iodoethyl group, 2-iodoisobutyl group, 1,2-diiodoethyl group, 1,3-diiodoisopropyl group, 2,3-diiodo-t-butyl group, 1.2,3-triiodopropyl group, aminomethyl group, 1-aminoethyl group, 2-aminoethyl group, 2-aminoisobutyl group, 1,2-diaminoethyl group, 1,3-diaminoisopropyl group, 2,3-diamino-t-butyl group, 1,2,3-triaminopropyl group, cyanomethyl group, 1-cyanoethyl group, 2-cyanoethyl group, 2-cyanoisobutyl group, 1,2-dicyanoethyl group, 1,3-dicyanoisopropyl group, 2,3-dicyano-t-butyl group, 1,2,3-tricyanopropyl group, nitromethyl group, 1-nitroethyl group, 2-nitroethyl group, 1,2-dinitroothyl group, 2,3-dinitro-t-butyl group, 1,2,3-trinitropropyl group, trifluoromethyl group, perfluoroethyl group, perfluoropropyl group, perfluorobutyl group, perfluoropentyl group, perfluorohexyl group, 1H,1H-perfluoroethyl group, 1H,1H-perfluoropropyl group, 1H,1H-perfluorobutyl group, 1H,1H-perfluoropentyl group, and 1H,1H-perfluorohexyl group, with methyl group, ethyl group, propyl group, isopropyl group, n-butyl group, s-butyl group, isobutyl group, t-butyl group, n-pentyl group, n-hexyl group, n-heptyl group, n-octyl group, n-nonyl group, n-decyl group, n-undecyl group, n-dodecyl group, n-tridecyl group, n-tetradecyl group, n-pentadecyl group, n-hexadecyl group, n-heptadecyl group, n-octaclecyl group, neopentyl group, 1-methylpentyl group, 1-pentylhexyl group, 1-butylpentyl group, and 1-heptyloctyl group being preferred.

Examples of the substituted or unsubstituted cycloalkyl group having 3 to 30 ring-forming carbon atoms for X¹ to X¹⁰ include cyclopentyl group, cyclohexyl group, cyclooctyl group, and 3,5-tetramethylcyelohexyl group, with cyclohexyl group, cyclooctyl group, and 3,5-tetramethyleyelohexyl group being preferred.

The substituted or unsubstituted alkoxy group having 1 to 30 carbon atoms for X¹ to X¹⁰ may be linear or branched and is represented by -OY¹ wherein Y¹ is an alkyl group. Y¹ and preferred Y¹ are selected from the alkyl groups and preferred alkyl groups each mentioned above.

The substituted or unsubstituted cycloalkyloxy group having 3 to 30 ring-forming carbon atoms for X¹ to X¹⁰ is represented by -OY² wherein Y² is a cycloalkyl group. Y² and preferred Y² are selected from the cycloalkyl groups and preferred cycloalkyl groups each mentioned above.

The substituted or unsubstituted arylthio group having 1 to 30 carbon atoms for X¹ to X¹⁰ may be linear or branched and is represented by -SY³ wherein Y³ is an alkyl group. Y³ and preferred Y³ are selected from the alkyl groups and preferred alkyl groups each mentioned above.

The substituted or unsubstituted cycloalkylthio group having 3 to 30 ring-forming carbon atoms for X¹ to X¹⁰ is represented by -SY⁴ wherein Y⁴ is a cycloalkyl group. Y⁴ and preferred Y⁴ are selected from the cycloalkyl groups and preferred cycloalkyl groups each mentioned above.

The substituted or unsubstituted alkenyl group having 2 to 30 carbon atoms for X¹ to X¹⁰ may be linear or branched and examples thereof include vinyl group, allyl group, 1-butenyl groups, 2-butenyl group, 3-butenyl group, 1,3-butanedienyl group, 1-mothylvinyl group, styryl group, 2,2-diphenylvinyl group, 1,2-diphenylvinyl group, 1-methylallyl group, 1,1-dimothylanyl group, 2-methylallyl groups, 1-phenylallyl group, 2-phonylallyl group, 3-phenylallyl group, 3,3-diphenylallyl group, 1,2-dimethylallyl group, 1-phenyl-1-butenyl group, and 3-phenyl-1-butenyl group, with styryl group, 2,2-diphenylvinyl group, and 1,2-diphenylvinyl group being preferred.

Examples of the substituted or unsubstituted cycloalkenyl group having 3 to 30 ring-forming carbon atoms for X¹ to X¹⁰ include cyclopentenyl group, cyclohexenyl group, cyclooctenyl group, and 3,5-tetramethylcyclohexenyl group, with cyclohexenyl group, cyclooctenyl group, and 3,5-tetramethylcyclohexenyl group being preferred.

The substituted or unsubstituted alkenyloxy group having 2 to 30 carbon atoms for X¹ to X¹⁰ may be linear or branched and is represented by -OY⁵ wherein Y⁵ is an alkenyl group. Y⁵ and preferred Y⁶ are selected from the alkenyl groups and preferred alkenyl groups each mentioned above.

The substituted or unsubstituted cycloalkenyloxy group having 3 to 30 ring-forming carbon atoms for X¹ to X¹⁰ is represented by -OY⁶ wherein Y⁶ is a cycloalkenyl group. Y⁶ and preferred Y⁶ are selected from the cycloalkenyl groups and preferred cycloalkenyl groups each mentioned above.

The substituted or unsubstituted alkenylthio group having 2 to 30 carbon atoms for X¹ to X¹⁰ may be linear or branched and is represented by -SY⁷ wherein Y⁷ is an alkenyl group. Y⁷ and preferred Y⁷ are selected from the alkenyl groups and preferred alkenyl groups each mentioned above.

The substituted or unsubstituted cycloalkenylthio group having 3 to 30 ring-forming carbon atoms for X¹ to X¹⁰ is represented by -SY⁸ wherein Y⁸ is a cycloalkenyl group. Y⁸ and preferred Y⁸ are selected from the cycloalkenyl groups and preferred cycloalkenyl groups each mentioned above.

Examples of the substituted or unsubstituted aralkyl group having 7 to 30 carbon atoms for X¹ to X¹⁰ include benzyl group, 1-phenylethyl group, 2-phenylethyl group, 1-phenylisopropyl group, 2-phenylisopropyl group, plienyl-t-butyl group, α-naphthylmethyl group, 1-α-naphthylethyl group, 2-α-naphthylethyl group, 1-α-naphthylisopropyl group, 2-α-naphthylisopropyl group, β-naphthylmethyl group, 1-β-naphthylethyl group, 2-β-naphthylethyl group, 1-β-naphthynsopropyl group, 2-β-naphthylisopropyl group, 1-pyrrolylmethyl group, 2-(1-pyrrolyl)ethyl group, p-methylbenzyl group, m-methylbenzyl group, o-methylbenzyl group, p-chlorobenzyl group, m-chlorobenxyl group, o-chlorobenzyl group, p-bromobenzyl group, m-bromobenzyl group, o-bromobenzyl group, p-iodobenxyl group, m-iodobenzyl group, o-iodobenzyl group, p-hydroxybenzyl group, m-hydroxybenzyl group, o-bydroxybenzyl group, p-aminobenzyl group, m-aminobenzyl group, o-aminobenzyl group, p-nitrobenzyl group, m-nitrobenzyl group, o-nitrobenzyl group, p-cyanobenzyl group, m-cyanobenzyl group, o-cyanobenzyl group, 1-hydroxy-2-phenylisopropyl group, and 1-chloro-2-phenylisopropyl group, with benzyl group, p-cyanobenzyl group, m-cyanobenzyl group, o-cyanobenzyl group, 1-phenylethyl group, 2-phenylethyl group, 1-phenylisopropyl group, and 2-phenylisopropyl group bering preferred.

The substituted or unsubstituted aralkyloxy group having 7 to 30 carbon atoms for X¹ to X¹⁰ is represented by -OY⁹ wherein Y⁹ is an aralkyl group. Y⁹ and preferred Y⁹ are selected from the aralkyl groups and preferred aralkyl groups each mentioned above.

The substituted or unsubstituted aralkylthio group having 7 to 30 carbon atoms for X¹ to X¹⁰ is represented by -SY¹⁰ wherein Y¹⁰ is an aralkyl group. Y¹⁰ and preferred Y¹⁰ are selected from the aralkyl groups and preferred aralkyl groups each mentioned above.

Examples of the substituted or unsubstituted aryl group having 6 to 20 ring-forming carbon atoms for X¹ to X¹⁰ include phenyl group, 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group, 1-naphthacenyl group, 2-naphthacenyl group, 9-naphthacenyl group, 1-pyrenyl group, 2-pyrenyl group, 4-pyrenyl group, 2-biphenylyl group, 3-biphenylyl group, 4-biphenylyl group, p-terphenyl-4-yl group, p-terphenyl-3-yl group, p-terphenyl-2-yl group, m-terphenyl-4-yl group, m-terphonyl-3-yl group, m-terphenyl-2-yl group, o-tolyl group, m-tolyl group, p-tolyl group, p-t-butylphenyl group, p-(2-phenylpropyl)phenyl group, 3-methyl-2-naphthyl group, 4-methyl-1-naphthyl group, 4-methyl-1-anthryl group, 4'-methylbiphenylyl group, 4"-t-butyl-p-terphenyl-4-yl group, o-cumenyl group, m-cumenyl group, p-cumenyl group, 2,3-xylyl group, 3,4-xylyl group, 2,5-xylyl group, and mesityl group, with phenyl group, 1-naphthyl group, 2-naphthyl group, 9-phenanthryl group, 2-biphenylyl group, 3-biphenylyl group, 4-biphenylyl group, p-tolyl group, and 3,4-xylyl group being preferred.

Examples of the substituted or unsubstituted heterocyclic group having 5 to 20 ring-forming carbon atoms for X¹ to X¹⁰ include 1-pyrrolyl group, 2-pyrrolyl group, 3-pyrrolyl group, pyrazinyl group, 2-pyridinyl group, 3-pyridinyl group, 4-pyridinyl groups, 1-indolyl group, 2-indolyl group, 3-indolyl group, 4-indolyl group, 5-indolyl group, 6-indolyl group, 7-indolyl group, 1-isoindolyl groups, 2-isoindolyl group, 3-isoindolyl group, 4-isoindolyl group, 5-isoindolyl group, 6-isoindolyl group, 7-isoindolyl group, 2-furyl group, 3-furyl group, 2-benzofuranyl group, 3-benzofuranyl group, 4-benzofuranyl group, 5-benzofuranyl group, 6-benzofuranyl group, 7-benzofuranyl group, 1-isobenzofuranyl group, 8-isobenzofuranyl group, 4-isobenzofuranyl group, 5-isobenzofuranyl group, 6-isobenzofuranyl group, 7-isobenzofuranyl group, 2-quinolyl group, 3-quinolyl group, 4-quinolyl group, 5-quinolyl group, 6-quinolyl group, 7-quinolyl group, 8-quinolyl group, 1-isoquinolyl group, 3-isoquinolyl group, 4-isoqmnolyl group, 5-isoquinolyl group, 6-isoquinolyl group, 7-isoquinolyl group, 8-isoquinolyl group, 2-quinoxalinyl group, 5-quinoxalinyl group, 6-quinoxalinyl group, 1-carbazolyl group, 2-carbazolyl group, 8-carbazolyl group, 4-carbazolyl group, 9-carbazolyl group, 1-phenanthridinyl group, 2-phenanthridinyl group, 3-phenanthridinyl group, 4-phonanthridinyl group, 6-phenanthridinyl group, 7-phenanthridinyl group, 8-phenanthridinyl group, 9-phenanthridinyl groups, 10-phenanthridinyl group, 1-acridinyl group, 2-acridinyl group, 3-acridinyl group, 4-acridinyl group, 9-acridinyl group, 1,7-phenanthrolin-2-yl group, 1,7-phenanthrolin-3-yl group, 1,7-phenanthrolin-4-yl group, 1,7-phenanthrolin-5-yl group, 1,7-phenanthrolin-6-yl group, 1,7-phenanthrolin-8-yl group, 1,7-phenanthrolin-9-yl group, 1,7-phenanthrolin-10-yl group, 1,8-phenanthrolin-2-yl group, 1,8-phenanthrolin-3-yl group, 1,8-phenanthrolin-4-yl group, 1,8-phenanthrolin-5-yl group, 1,8-phenanthrolin-6-yl group, 1,8-phenanthrolin-7-yl group, 1,8-phenanthrolin-9-yl group, 1,8-phenanthrolin-10-yl group, 1,9-phenanthrolin-2-yl group, 1,9-phenanthrolin-3-yl group, 1,9-phenanthrolin-4-yl group, 1,9-phenanthrolin-5-yl group, 1,9-phenanthrolin-6-yl group, 1,9-phenanthxolin-7-yl group, 1,9-phenanthrolin-8-yl group, 1,9-phenanthrolin-10-yl group, 1,10-phenanthrolin-2-yl group, 1,10-phenanthrolin-3-yl group, 1,10-phenanthrolin-4-yl group, 1,10-phenanthrolin-5-yl group, 2,9-phenanthrolin-1-yl group, 2,9-phenanthrolin-3-yl group, 2,9-phenanthrolin-4-yl group, 2,9-phenanthrolin-5-yl group, 2,9-phenanthrolin-6-yl group, 2,9-phenanthrolin-7-yl group, 2,9-phenanthrolin-8-yl group, 2,9-phenanthrolin-10-yl group, 2,8-phenanthrolin-1-yl group, 2,8-phenanthrolin-3-yl group, 2,8-phenanthrolin-4-yl group, 2,8-phenanthrolin-5-yl group, 2,8-phenanthrolin-6-yl group, 2,8-phenanthrolin-7-yl group, 2,8-phenanthrolin-9-yl group, 2,8-phenanthrolin-10-yl group, 2,7-phenanthrolin-1-yl group, 2,7-phenanthrolin-3-yl group, 2,7-phenanthrolin-4-yl group, 2,7-phenanthrolin-,5-yl group, 2,7-phenanthrolin-6-yl group, 2,7-phenanthrolin-8-yl group, 2,7-phenanthrolin-9-yl group, 2,7-phenanthrolin-10-yl group, 1-phenazinyl group, 3-phenazinyl group, 1-phenothiazinyl group, 2-phenothiazinyl group, 3-phenothiazinyl group, 4-phenothiazinyl group, 10-phenothiazinyl group, 1-phenoxazinyl group, 2-phenoxazinyl group, 3-phenoxazinyl group, 4-phenoxazinyl group, 10-phenoxazinyl group, 2-oxazolyl group, 4-oxazolyl group, 5-oxazolyl group, 2-oxadiazolyl group, 5-oxadiazolyl group, 3-furazanyl group, 2-thienyl group, 3-thienyl group, 2-methylpyrrol-1-yl group, 2-methylpyrrol-3-yl group, 2-methylpyrrol-4-yl group, 2-methylpyrrol-5-yl group, 3-methylpyrrol-1-yl group, 3-methylpyrrol-2-yl group, 3-meihylpyrrol-4-yl group, 3-methylpyrrol-5-yl group, 2-t-butylpyrrol-4-yl group, 3-(2-phenylpropy)pyrrol-1-yl group, 2-methyl-1-indolyl group, 4-methyl-1-indolyl group, 2-methyl-3-indolyl group, 4-methyl-3-indolyl group, 2-t-butyl-1-indolyl group, 4-t-butyl-1-indolyl group, 2-t-butyl-3-indolyl group, 4-t-butyl-3-indolyl group, 5-methylthienyl group, 2-dibenzofuranyl group, and 4-dibenzofuranyl group, with 2-pyridinyl group, 4-pyridinyl group, 1-indolyl group, 4-indolyl group, 5-indolyl group, 6-indolyl group, 7-indolyl group, 2-quinolyl group, 3-quinolyl group, 5-quinolyl group, 6-quinolyl group, 1-isoquinolyl group, 4-isoquinolyl group, 5-isoquinolyl group, 8-isoquinolyl group, 4-methyl-1-indolyl group, 3-carbazolyl group, 9-carbazolyl group, 1,10-phenanthrolin-3-yl group, 1,10-phenanthrolin-5-yl group, 5-methylthienyl group, 2-dibenzofuranyl group, and 4-dibenzofuranyl group being preferred.

The substituted or unsubstituted aryloxy group having 6 to 20 ring-forming carbon atoms for X¹ to X¹⁰ is represented by -OY¹¹ wherein Y¹¹ is an aryl group. Y¹¹ and preferred Y¹¹ are selected from the aryl groups and preferred aryl groups each mentioned above.

The substituted or unsubstituted arylthio group having 6 to 20 ring-forming carbon atoms for X¹ to X¹⁰ is represented by -SY¹² wherein Y¹² is an aryl group. Y¹² and preferred Y¹² are selected from the aryl groups and preferred aryl groups each mentioned above.

The mono- or disubstituted amino group having 1 to 30 carbon atoms for X¹ to X¹⁰ is represented by -NQ¹Q² wherein Q¹ and Q² are each independently hydrogen atom, an alkyl group, an aryl group or an aralkyl group, with the proviso that Q¹ = Q² = hydrogen atom is excluded. The alkyl group, aryl groups, aralkyl group, and respective preferred groups for Q¹ and Q² are selected from the alkyl groups and preferred alkyl group, the aryl groups and preferred aryl group, and the aralkyl groups and preferred aralkyl groups each mentioned above.

Examples of the substituted silyl group for X¹ to X¹⁰ include trimethylsilyl group, triethylsilyl group, t-butyldimethylsilyl group, vinyldimethylsilyl group, propyldimethylsilyl group, and triphenylsilyl group, with trimethylsilyl group, triethylsilyl group, and t-butyldimethylsilyl group being preferred.

The substituted or unsubstituted alkyl group having 1 to 30 carbon atoms, the substituted or unsubstituted cycloalkyl group having 3 to 30 ring-forming carbon atoms, the substituted or unsubstituted alkenyl group having 2 to 30 carbon atoms, the substituted or unsubstituted cycloalkenyl group having 3 to 30 ring-forming carbon atoms, the substituted or unsubstituted aralkyl group having 7 to 30 carbon atoms, the substituted or unsubstituted aryl group having 6 to 30 ring-forming carbon atoms, and respective preferred groups for R¹⁰, R¹¹ and R¹² of -COOR¹⁰, -COR¹¹ and -OCOR¹² are selected from respective groups and their preferred groups each mentioned above.

Hydrogen atom and the substituted or unsubstituted aryl group having 6 to 20 carbon atoms are particularly preferred for X¹ to X¹⁰.

The compound of formula (1) may be a compound in which the adjacent X¹ and X² are bonded to each other to form a ring together with the carbon atoms to which X¹ and X² are bonded, which is represented by any one of formulae (1a) to (1c): 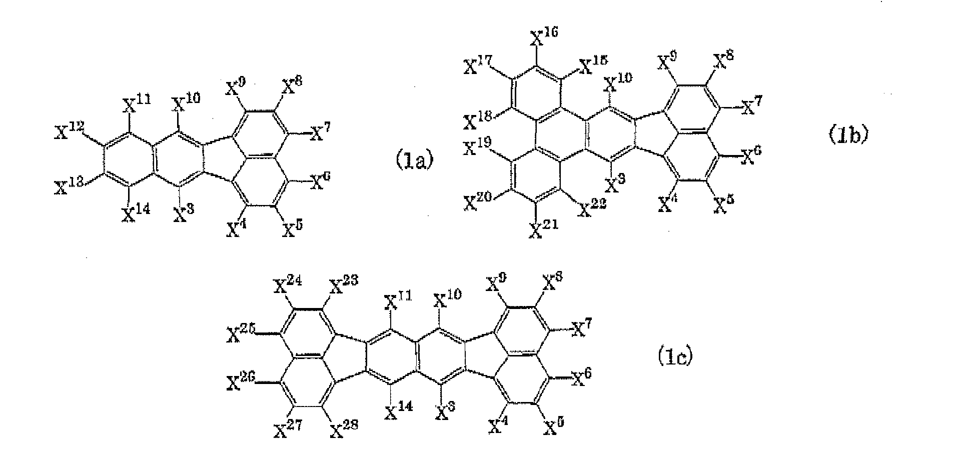 wherein X³ to X¹⁰ are as defined above and X¹¹ to X²⁸ are each independently selected from the groups as mentioned with respect to X³ to X¹⁰.

Examples of the compound of formulae (1) are described below, although not limited thereto.

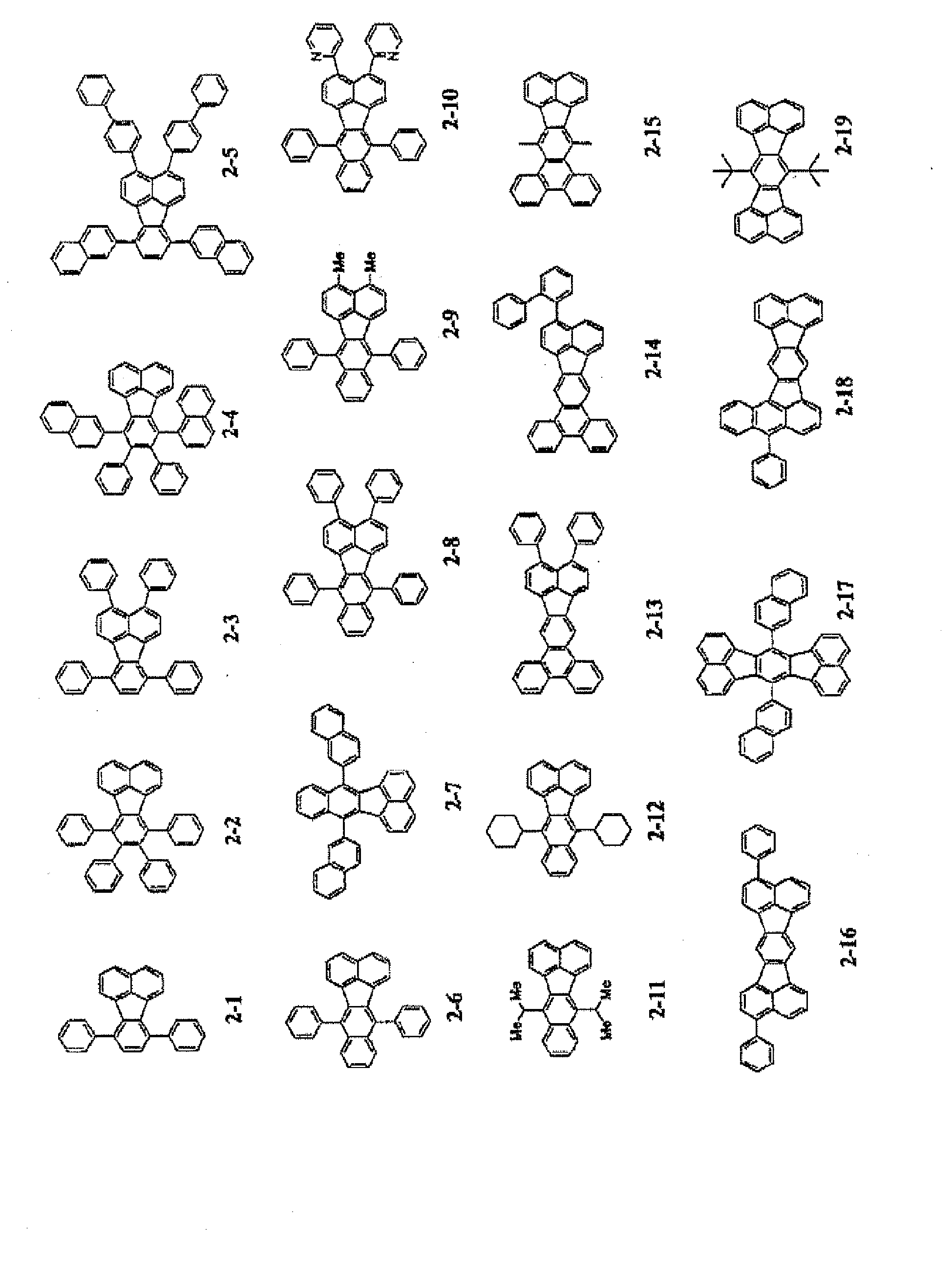

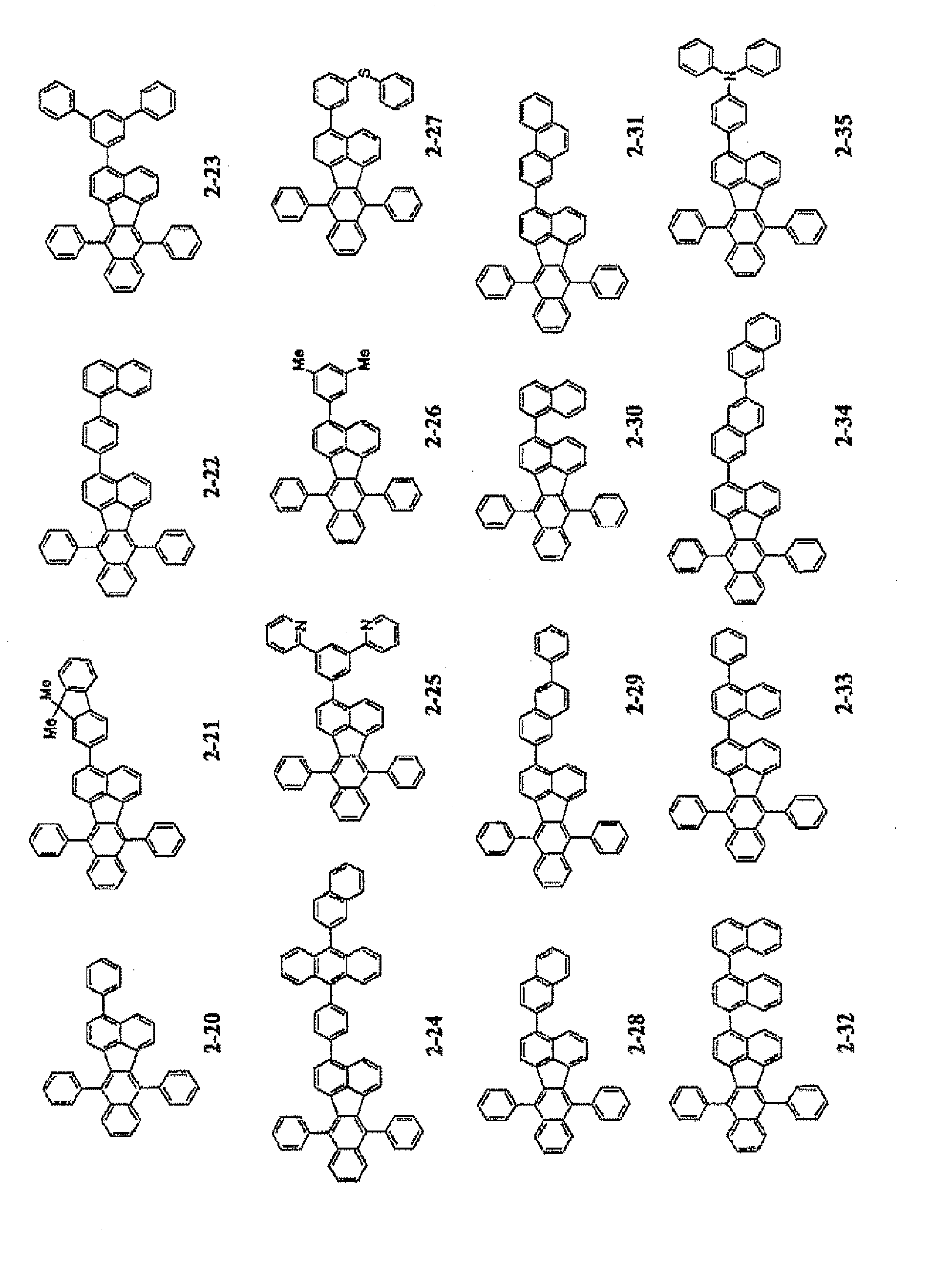

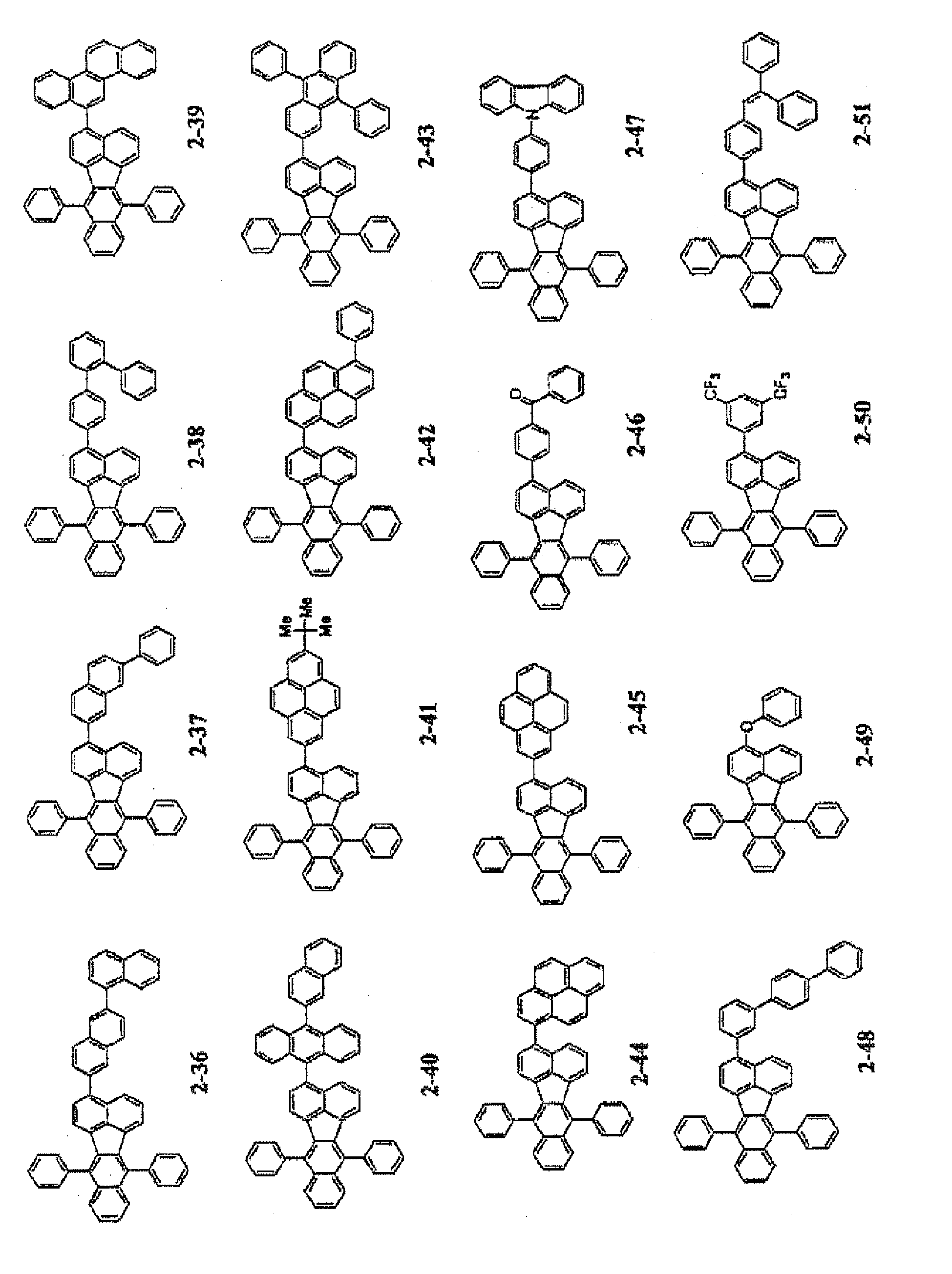

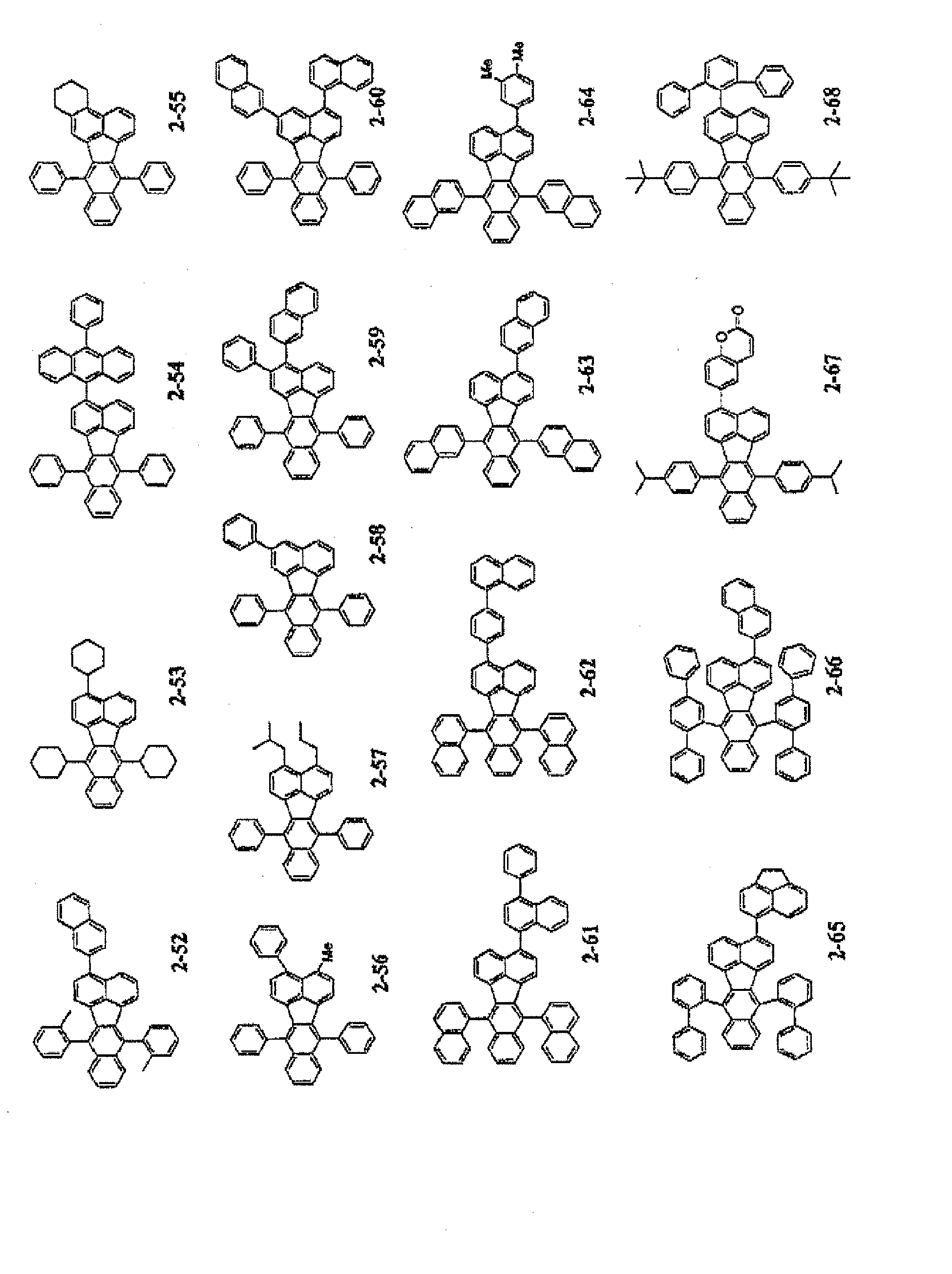

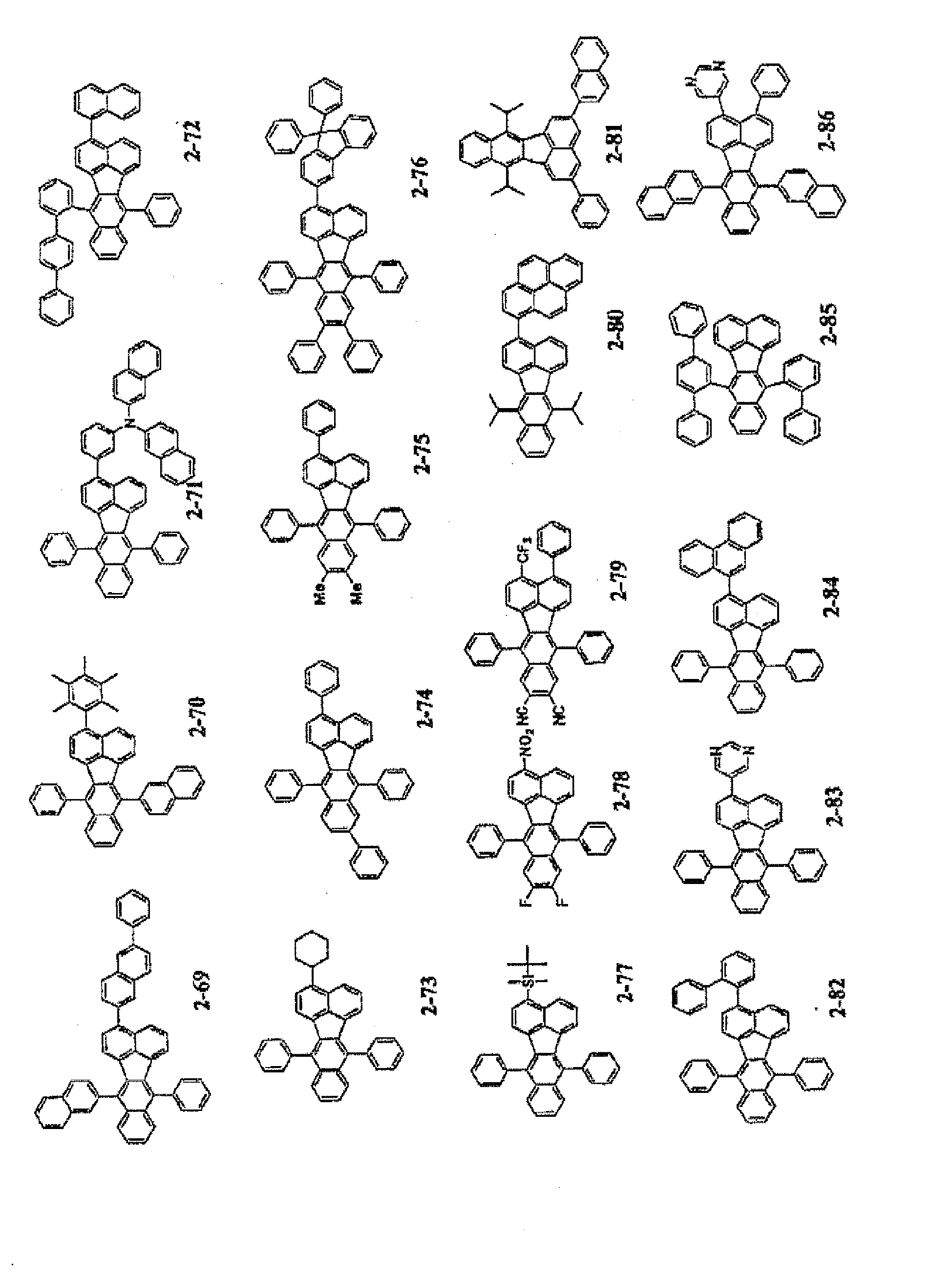

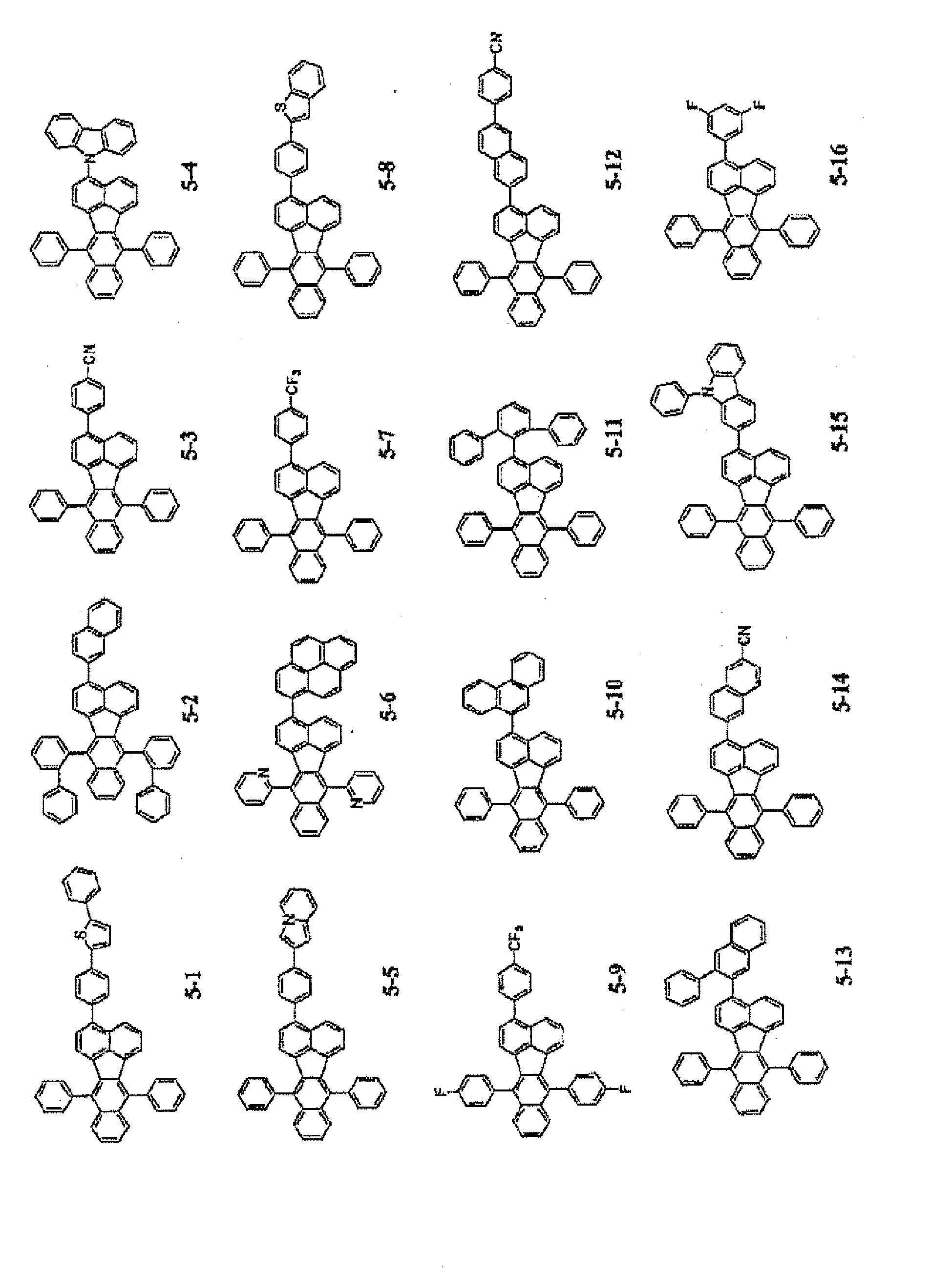

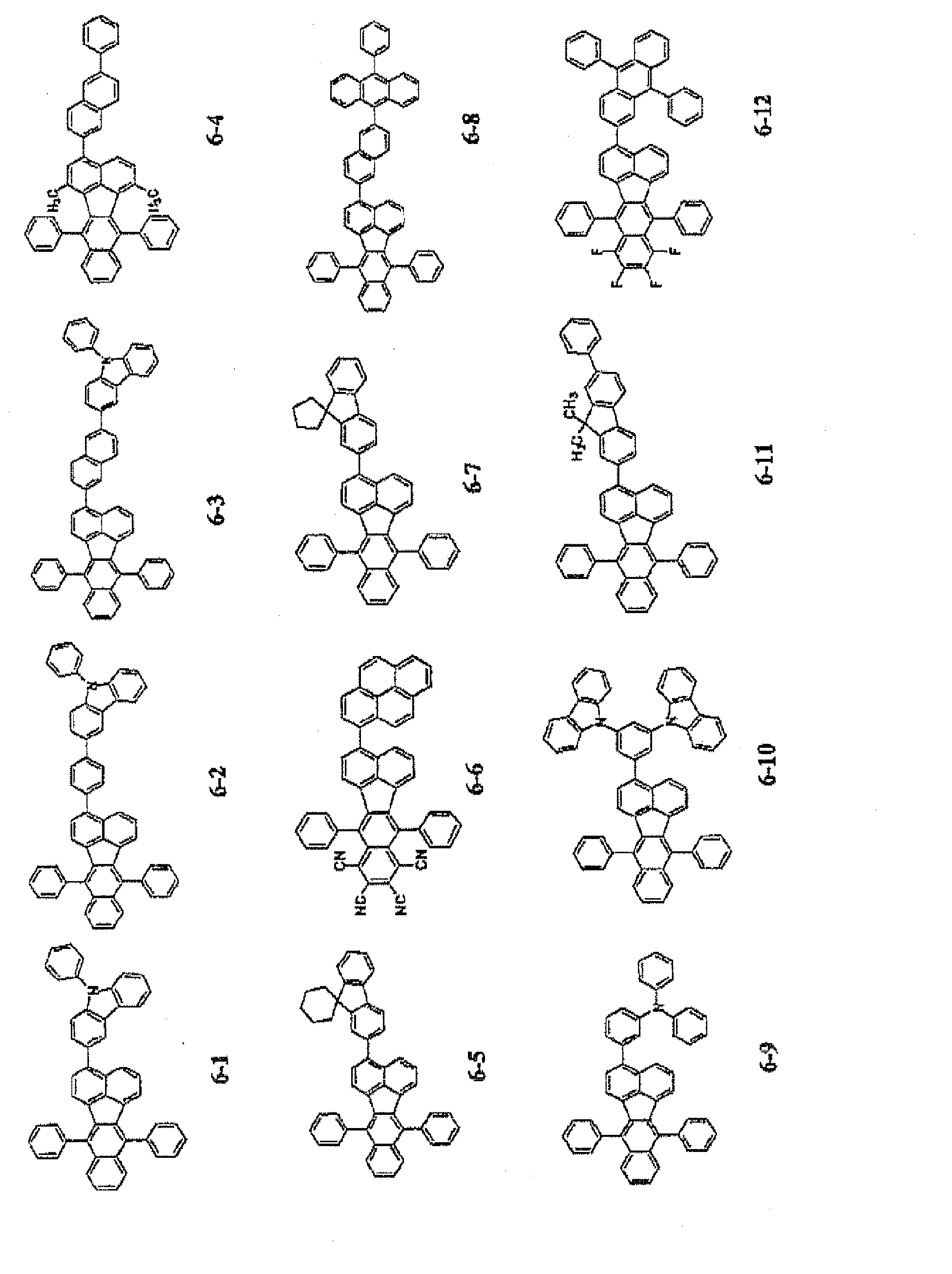

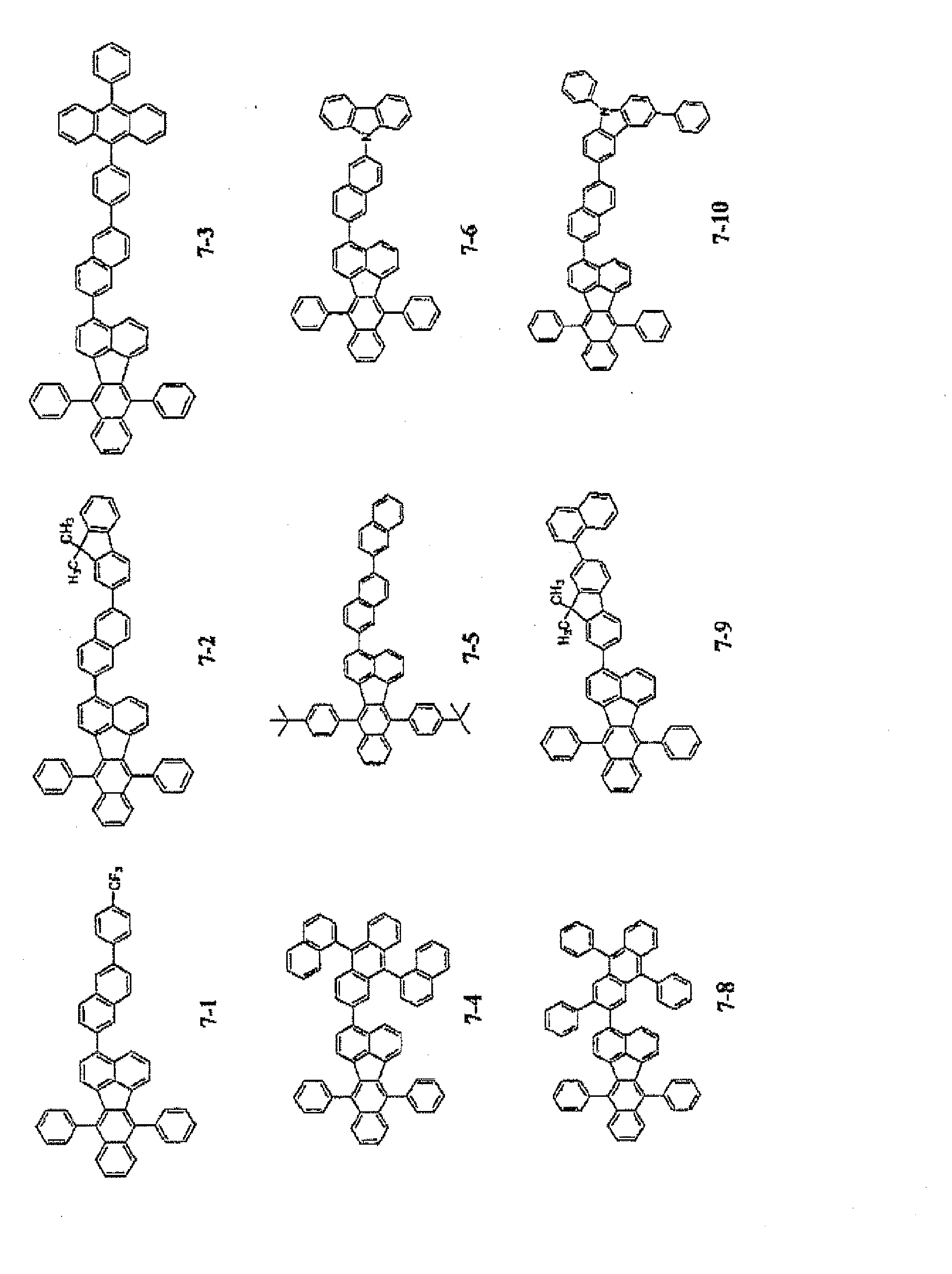

The divalent repeating unit derived from the compound of formula (I) has two valences on any benzene ring of the compounds of formulae (I) and (1a) to (1c) and the exemplary compounds described above. Two valences may be on different benzene rings or the same benzene ring.

In addition to the repeating unit A, the polymer of the invention further comprises a divalent repeating unit (repeating unit B) derived from the compounds represented by formulae (2) to (9):

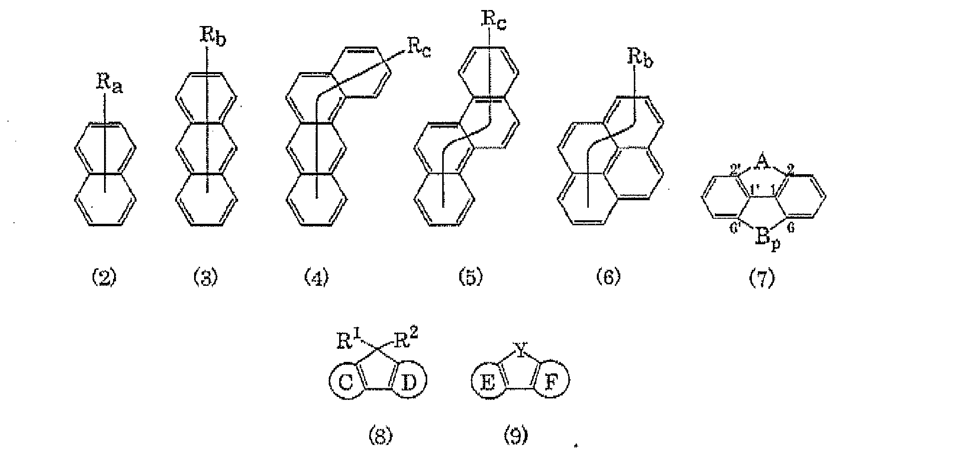

In formulae (2) to (6), R is a substituted or unsubstituted aryl group having 6 to 40 ring-forming carbon atoms, a substituted or unsubstituted heterocyclic group having 3 to 40 ring-forming atoms or a substituted or unsubstituted alkyl group having 1 to 50 carbon atoms; a is an integer of 0 to 8; b is an integer of 0 to 10; and c is an integer of 0 to 12. The aryl group, heterocyclic group and alkyl group are respectively selected from the substituted or unsubstituted aryl group, substituted or unsubstituted heterocyclic group and substituted or unsubstituted alkyl group which are mentioned above. In formulae (2) to (6), R may bond to any benzene ring and 2 or more R groups may bond to the same benzene ring.

Preferred compounds of formula (3) are

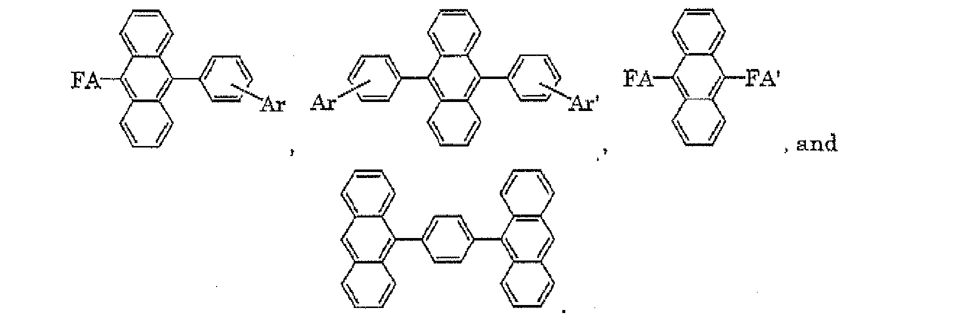

In the above formulae, Ar and Ar' are each independently a substituted or unsubstituted acryl group having 6 to 40 ring-forming carbon atoms, a substituted or unsubstituted heterocyclic group having 3 to 40 ring-forming atoms, a substituted or unsubstituted benzyl group, or a substituted or unsubstituted alkyl group having 1 to 50 carbon atoms. These groups are respectively selected from the substituted or unsubstituted aryl groups, substituted or unsubstituted heterocyclic groups and substituted or unsubstituted alkyl croup which are mentioned above. FA and FA' are each independently a substituted or unsubstituted aryl group having 6 to 30 ring-forming carbon atoms and selected from the substituted or unsubstituted aryl groups which are mentioned above. FA and FA' may be a condensed aryl group.

In formula (7), A is a substituted or unsubstituted divalent saturated group (substituent of A may have an unsaturated group) which forms a 5- to 8-membered ring together with the carbon atoms at 1, 2,1', and 2' positions of the biphenyl structure. B is a substituted or unsubstituted divalent saturated group (substituent of B may have an unsaturated group) which forms a 5- to 8-membered ring together with the carbon atoms at 1, 6, 1', and 6' positions of the biphenyl structure. A and B may be the same or different. The subscript p is 0 or 1. When p is 0, no bond is formed between the carbon atoms at 6 and 6' positions. The ring structure formed by a substituted A and the carbon atoms at 1, 2, 1', and 2' positions and/or the ring structure formed by a substituted B and the carbon atoms at 1, 6, 1', and 6' positions may have a spiro-ring structure. The atoms for forming A or B may include C, Si, O, S, N, B, P, and combination thereof. Examples of A and B are described below, although not limited thereto.

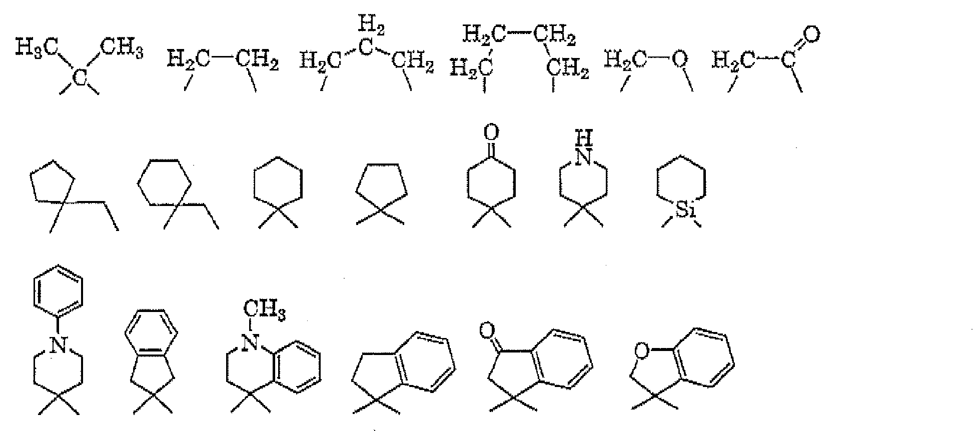

Examples of the compound of formulae (2) to (6) are described, for example, in JP 2002-243545A, JP 2003-401038A, JP 2003-423317A, WO 01/172673, and WO 2007/004364.

In formula (8), a ring C and a ring D are each independently an aromatic hydrocarbon ring having 6 to 40 ring-forming carbon atoms. At least one of the ring C and the ring D is an aromatic hydrocarbon ring comprising two or more condensed benzene rings. R¹ and R² are each independently hydrogen atom, an alkyl group having 1 to 30 carbon atoms, an alkoxy group having 1 to 30 carbon atoms, an alkylthio group having 1 to 30 carbon atoms, an aryl group having 6 to 20 ring-forming carbon atoms, an aryloxy group having 6 to 20 ring-forming carbon atoms, an arylthio group having 6 to 20 ring-forming carbon atoms, an aralkyl group having 7 to 30 carbon atoms, an aralkyloxy group having 7 to 30 carbon atoms, an aralkylthio group having 7 to 30 carbon atoms, an arylalkenyl group having 8 to 30 carbon atoms, an arylalkynyl group having 8 to 30 carbon atoms, amino group, a mono- or disubstituted amino group having 1 to 30 carbon atoms, silyl group, a mono-, di- or trisubstituted silyl group having 1 to 30 carbon atoms, a halogen atom, -COR¹¹ group wherein R¹¹ is as defined above, -OCOR¹² group wherein R¹² is as defined above, an imine residue having 2 to 30 carbon atoms, an amido group having 2 to 30 carbon atoms, an acid imido group having 3 to 30 carbon atoms, a heterocyclic group having 5 to 20 ring-forming carbon atoms, -COOR¹⁰ group wherein R¹⁰ is as defined above, nitro group, or cyano group. R¹ and R² may be bonded to each other to form a ring.

In formula (9), a ring E and a ring F are each independently an aromatic hydrocarbon ring having 6 to 40 ring-forming carbon atoms. Y is oxygen atom, sulfur atom, or -O-C(R³)₂- wherein two R³ groups are each independently hydrogen atom, an alkyl group having 1 to 30 carbon atoms, an alkoxy group having 1 to 30 carbon atoms, an alkylthio group having 1 to 30 carbon atoms, an aryl group having 6 to 20 ring-forming carbon atoms, an aryloxy group having 6 to 20 ring-forming carbon atoms, an arylthio group having 6 to 20 ring-forming carbon atoms, an aralkyl group having 7 to 30 carbon atoms, an aralkyloxy group having 7 to 30 carbon atoms, an aralkylthio group having 7 to 30 carbon atoms, an arylalkenyl group having 8 to 30 carbon atoms, an arylalkynyl group having 8 to 30 carbon atoms, amino group, a mono- or disubstituted amino group having 1 to 30 carbon atoms, silyl group, a mono-, di- or trisubstituted silyl group having 1 to 30 carbon atoms, halogen atom, -COR¹¹ wherein R¹¹ is as defined above, -OCOR¹² wherein R¹² is as defined above, an imine residue having 2 to 30 carbon atoms, an amido group having 2 to 30 carbon atoms, an acid imido group having 3 to 30 carbon atoms, a heterocyclic group having 5 to 20 ring-forming carbon atoms, -COOR¹⁰ wherein R¹⁰ is as defined above, nitro group, or cyano group. Two R³ groups may be the same or different.

The aromatic hydrocarbon ring for the rings C to F of formulae (8) and (9) is preferably a single benzene ring or a condensed ring of two or more benzene rings, each being optionally substituted. Examples of the aromatic hydrocarbon ring include benzene ring, naphthalene ring, anthracene ring, tetracene ring, pentacene ring, pyrene ring, and phenanthrene ring.

Examples of the substituted or unsubstituted arylalkenyl group having 8 to 30 carbon atoms for R¹ and R² of formula (8) and R³ of -O-C(R3)₂- of Y in formula (9) (hereinafter referred to as "R¹ and R³ of formulae (8) and (9)") include a phenyl-C2-C12 alkenyl group, a C1-C12 alkoxyphenyl-C2-C12 alkenyl group, a C1-C12 alkylphenyl-C2-C12 alkenyl group, a 1-naphthyl-C2-C12 alkenyl group, and a 2-naphthyl-C2-C13 alkenyl group.

Examples of the substituted or unsubstituted arylalkynyl group having 8 to 30 carbon atoms for R¹ to R³ of formulae (8) and (9) include a phenyl-C2-C12 alkynyl group, a C1-C12 alkoxyphenyl-C2-C13 alkenyl group, a C1-C12 alkylpheyl-C1-C12 alkenyl group, a 1-naphthyl·C2-C12 alkynyl group, and a 2-naphthyl-C2-C12 alkynyl group.

Examples of the mono-, di- or trisubstitutedsilyl group having 1 to 30 carbon atoms for R¹ to R³ of formulae (8) and (9) include trimethylsilyl group, triethylsilyl group, tripropylsilyl group, tri-1-propylsilyl group, dimethyl-1-propylsilyl group, diethyl-1-propylsilyl group, t-butylsilyldimethylsilyl group, pentyldimethylsilyl group, hexyldimethylsilyl group, heptyldimethylsilyl group, octyldimethylsilyl group, 2-ethylhexyl-dimethylsilyl group, nonyldimethylsilyl group, decyldimethylsilyl group, 3,7-dimethyloctyl-dimethylsilyl group, lauryldimethylsilyl group, a phenyl-C1-C12 alkylsilyl group, a C1-C12 alkoxyphenyl-C1-G12 alkylsilyl group, a C1-C12 alkylphenyl-01-C12 alkylsilyl group, a 1-naphthyl-C1-C12 alkylsilyl group, a 2-naphthyl-C1-C12 alkylsilyl group, a phenyl-C1-C12 alkyldimethylsilyl group, triphenylsilyl group, tri-p-xylylsilyl group, tribenzylsilyl group, diphenylmethylsilyl group, t-butyldiphonylsilyl group, and dimethylphenylsilyl group.

Examples of the substituted or unsubstituted imine residue having 2 to 30 carbon atoms for R¹ to R³ of formulae (8) and (9) include groups derived from the following imine compounds:

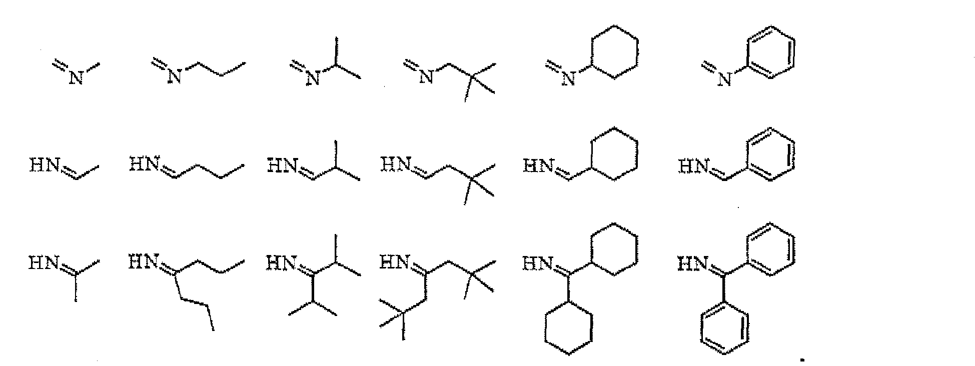

Example of the substituted or unsubstituted amido group having 2 to 30 carbon atoms for R¹ to R³ of formulae (8) and (9) include forma-naido group, acetamido group, propioamido group, butyroamido group, benzamido group, trifluoroacetamido group, pentafluorobenzamido group, diformamido group, diacetamido group, dipropioamido group, dibutyroamido group, dibenzamido group, ditrifluoroacetamido group, and dipentafluorobenzamido group.

Examples of the substituted or unsubstituted acid imido group having 3 to 30 carbon atoms for R¹ to R³ of formulae (8) and (9) include the following group

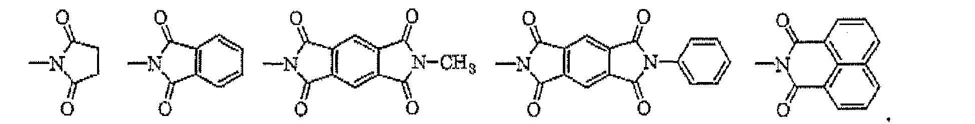

The other groups for R¹ to R³ of formulae (8) and (9) are selected from the group mentioned with respect to X¹ to X¹⁰.

Examples of the compound of formula (8) are described below, although not limited thereto.

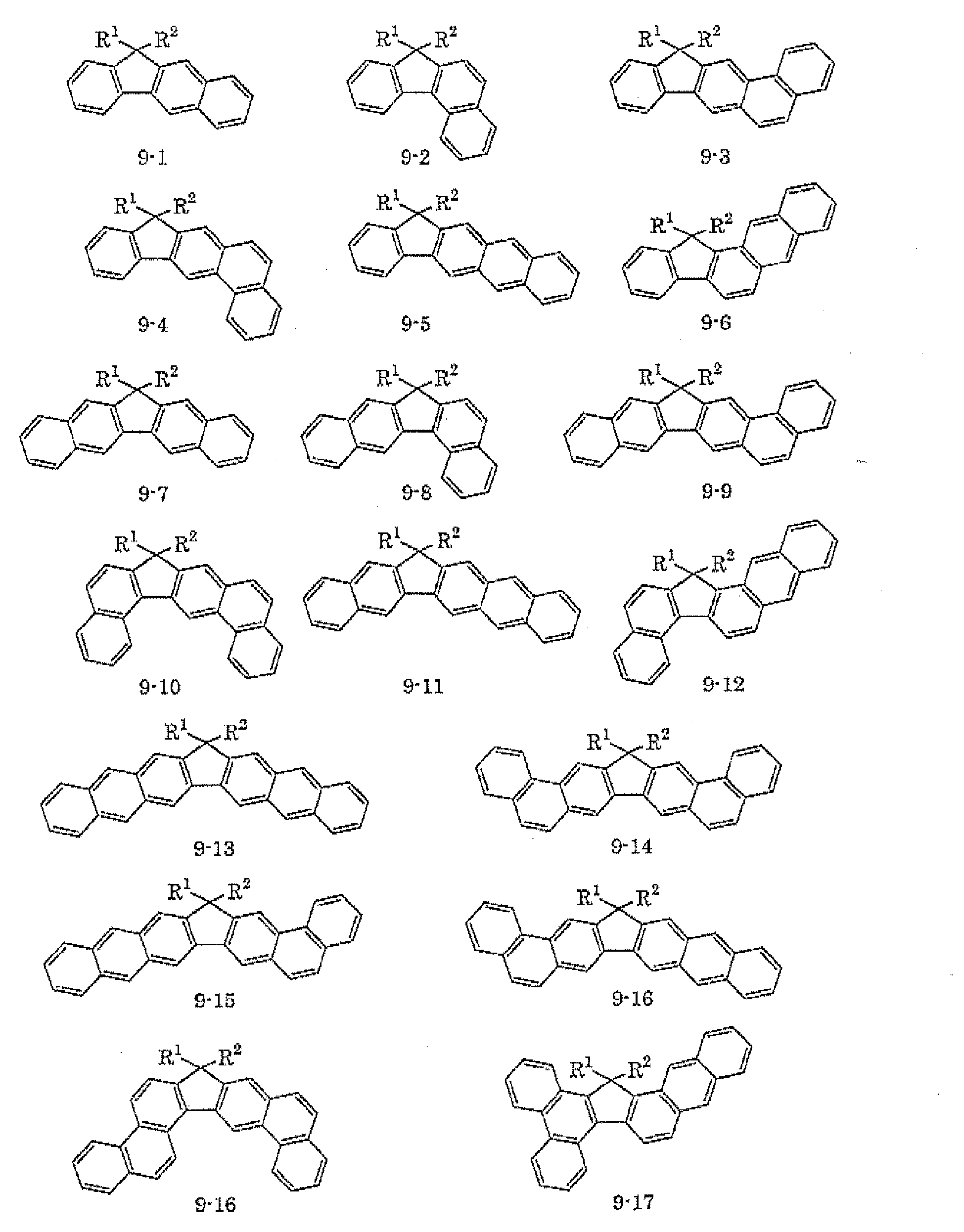

Examples of the compound of formula (9) are described below, although not limited thereto.

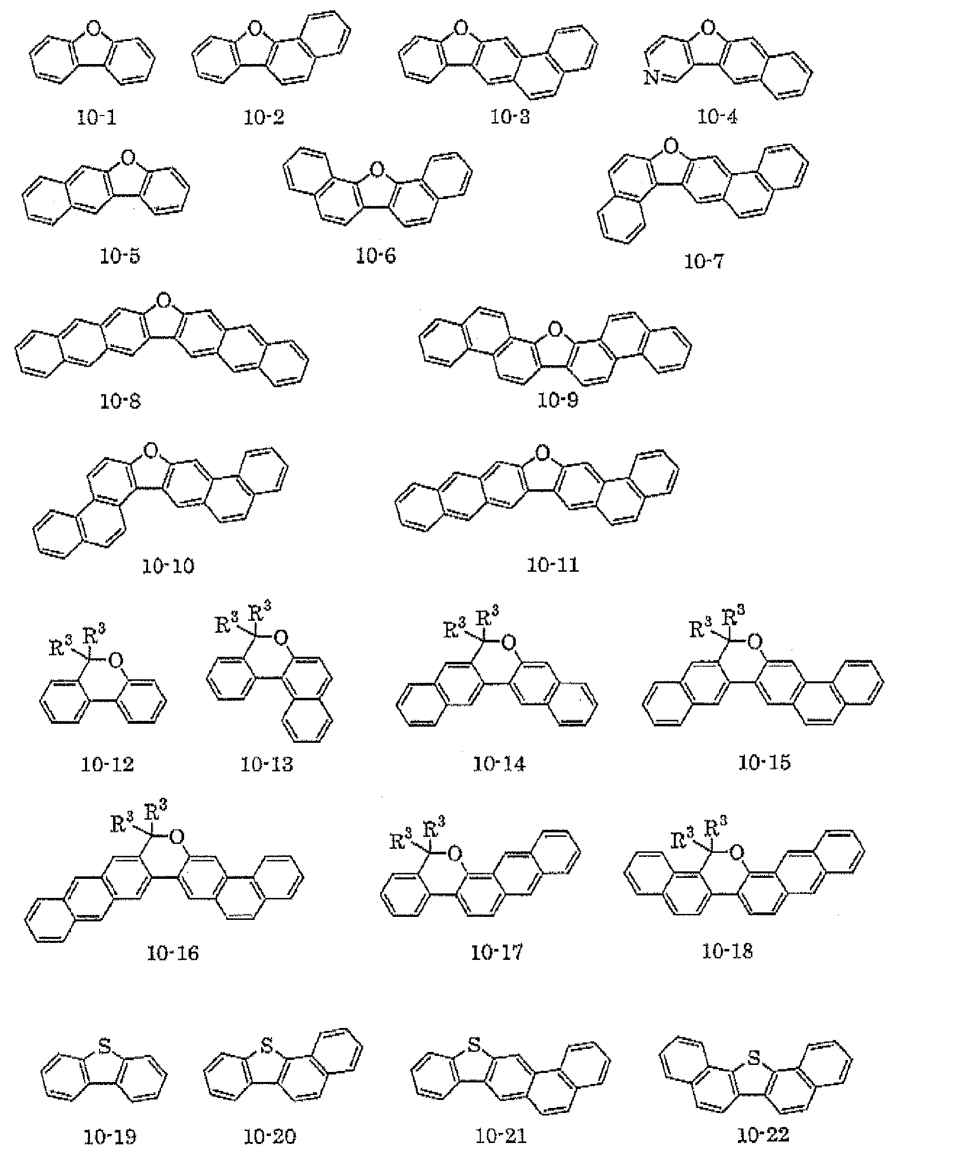

The repeating unit B derived from any of formulae (2) to (7) has its two valences on any benzene ring of formulae (2) to (7). Two valences may be positioned on different benzene rings or the same benzene ring. The repeating unit B derived from formula (8) or (9) has its tow valences on any of the ring C and the ring D, or any of the ring E and the ring F. Two valences may be positioned on different rings or the same ring.

Examples of the optional substituent for "a substituted or unsubstituted ... group" mentioned above include an alkyl group having 1 to 20 carbon atoms, a cycloalkyl group having 3 to 10 carbon atoms, an aryl group having 6 to 30 ring-forming carbon atoms, an alkoxy group having 1 to 20 carbon atoms, a cycloalkoxy group having 3 to 10 carbon atoms, an aryloxy group having 6 to 30 ring-forming carbon atoms, an aralkyl group having 7 to 31 carbon atoms (aryl moiety has 6 to 30 ring-forming carbon atoms), a heterocyclic group having 3 to 30 ring-forming carbon atoms, a mono- or dialkylamino group having alkyl group having 1 to 20 carbon atoms, a mono- or diarylamino group having aryl group having 6 to 30 ring-forming carbon atoms, a halogen atom, nitro group, cyano group, and hydroxyl group.

The polymer of the invention including the repeating units A and the repeating units B may be random copolymer (-ABBABBBAAABA-), alternating copolymer (-ABABABABABAB-), block copolymer (-AAAAAABBBBBB-), and graft copolymer comprising the side chain of repeating units A and the main chain of repeating units B, and vice versa.

The number average molecular weight (Mn) of the polymer is preferably 10³ to 10⁸, and more preferably 10⁴ to 10⁶. The weight average molecular weight (Mw) thereof is preferably 10³ to 10⁸, and more preferably 10⁵ to 10⁶. Both molecular weights were determined by size exclusion chromatography (SEC) using standard polystyrene calibration.

The content of the repeating unit A in one molecule of the polymer is preferably 0.1 to 50 mol%, more preferably 0.1 to 40 mol%, and still more preferably 0.1 to 10 mol% each based on the total of the repeating units.

The polymer of the invention is produced, for example, by the polycondensation of a compound represented by formula (10): 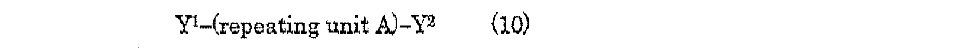 and a compound represented by formula (11)

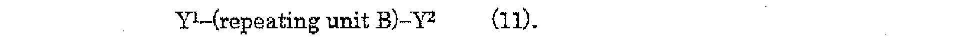

In formulae (10) and (11), Y¹ and Y² are each independently a halogen atom (chlorine atom, bromine atom, iodine atom), a sulfonate group (-OSO₂R¹, wherein R¹ is a group selected from the substituted or unsubstituted aryl group and the substituted or unsubstituted alkyl group which are mentioned with respect to Ar₁ to Ar₄), methoxy group, a boric ester group, a borate group (-B(OH)₂), -MgX¹ (X¹ is halogen atom such as chlorine atom, bromine atom, and iodine atom), -ZnX¹ (X¹ is as defined above), -SnR¹ (R¹ is as defined above), with halogen atom, boric ester group and borate group being preferred.

The boric ester group may include the following groups:

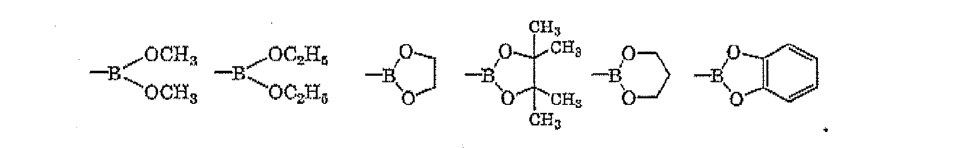

The polycondensation is conducted, if necessary, in the presence of a catalyst and a base. Examples of the catalyst include a transition metal complex such as a palladium complex, for example, palladium [tetrakis(triphenylphosphine)], [tris(dibenzylideneacetone)] dipalladium, and palladium acetate, and a nickel complex, for example, nickel [tetrakis(triphenylphosphine)], [1,3-bis(diphenylphosphino)propane] dichloronickel, and [bis(1,4-cyclooetadiene)] nickel; and a catalyst having a ligand such as triphenylphosphine, tri(t-butylphospbine), tricyclohexylphosphine, diphenylphosphinopropane, and bipyridyl. These catalysts may be used alone or in combination of two or more. The catalyst is used preferably 0.001 to 300 mol% and more preferably 0.01 to 20 mol% based on the total molar amount of the compounds of formulae (10) and (11).

Examples of the base include inorganic base such as sodium carbonate, potassium carbonate, cesium carbonate, potassium fluoride, cesium fluoride, and tripotassium phosphate; and organic base such as tetrabutylammonium fluoride, tetrabutylammonium chloride, tetrabutylammonium bromide, and tetrabutylammonium hydroxide. The base is used preferably 0.5 to 20 equivalents and more preferably 1 to 10 equivalents based on the total molar amount of the compounds of formulae (10) and (11).

The polycondensation may be conducted in the presence of an organic solvent. Examples of the organic solvent include toluene, xylene, mesitylene, tetrahydrofuran, 1,4-dioxane, dimethoxyethane. N,N-dimethylacetamide, and N,N-dimethylformamide. These organic solvents may be used alone or in combination of two or more. The organic solvent is used in an amount such that the concentration of the monomers (compounds of formulae (10) and (11)) is preferably 0.1 to 90% by weight and more preferably 1 to 50% by weight.

The temperature of polycondensation is not particularly limited as long as the reaction medium is kept in liquid state, and preferably -100 to 200 °C and more preferably 0 to 120 °C. The polycondensation time varies depending upon the reaction conditions, and preferably one hour or more, more preferably 2 to 500 h.

The aimed polymer is separated from the polycondensation product by a known method, for example, by adding the reaction product solution into a lower alcohol such as methanol, collecting the precipitates by filtration and drying the collected precipitates, If the purity is low, the polymer may be purified by a known method such as recrystallization, Soxhlet continuous extraction and column chromatography.

In the organic EL device of the invention, an organic compound layer comprising a layer is interposed between a pair of electrodes. At least one layer of the organic compound layer is a light-emitting layer. The thickness of the light-emitting layer is preferably 5 to 200 nm and more preferably 10 to 40 nm in view of a low driving voltage. The polymer of the invention is contained in at least one layer of the organic compound layer, preferably in the light-emitting layer. It is preferred to dispose intermediate layers of various types between the organic compound layer and each electrode. Examples of the intermediate layer include a hole injecting layer, a hole transporting layer, an electron injecting layer, and an electron transporting layer. These layers are formed from a known organic and inorganic compound, Examples of the typical architecture of the organic EL devices, but not particularly limited to, include
(1) anode/light-emitting layer/cathode,
(2) anode/hole injecting layer/light-emitting layer/cathode,
(3) anode/light-emitting layer/electron injecting layer/cathode,
(4) anode/hole injecting layer/light- emitting layer/electron injecting layer/cathode,
(5) anode/organic semiconductor layer/light-emitting layer/cathode,
(6) anode/organic semiconductor layer/electron blocking layer/light-emitting layer/cathode,
(7) anode/organic semiconductor layer/light-emitting layer/adhesion improving layer/cathode,
(8) anode/hole injecting layer/hole transporting layer/light-emitting layer/electron injecting layer/cathode,
(9) anode/insulating layer/light-emitting layer/insulating layer/cathode,
(10) anode/inorganic semiconductor layer/insulating layer/light-emitting layer/insulating layer/cathode,
(11) anode/organic semiconductor layer/insulating layer/light-emitting layer/insulating layer/cathode,
(12) anode/insulating layer/hole injecting layer/hole transporting layer/light-emitting layer/insulating layer/cathode, and
(13) anode/insulating layer/hole injecting layer/hole transporting layer/light-emitting layer/electron injecting layer/cathode, with the device structure (8) being preferably used.

The organic EL device is formed generally on a light-transmissive substrate. The light-transmissive substrate serves as a support for the organic EL device. A flat and smooth substrate having a transmittance of 50% or more to 400 to 700 nm visible lights is preferably used. A glass plate and a synthetic resin plate are preferably used as the light-transmissive substrate. Examples of the glass plate include those made from soda-lime glass, barium-strontium-containing glass, lead glass, aluminosilicate glass, borosilicate glass, barium borosilicate glass, or quartz. Examples of the synthetic resin plate include those made from polycarbonate resin, acrylic resin, polyethylene terephthalate resin, polyether sulfide resin or polysulfone resin.

The anode is preferably made from an electrode material having a large work function (4 eV or more), for example, a metal, an alloy, an electron-conductive compound and mixtures thereof. Examples of the electrode material for anode include a metal such as Au and an electron-conductive material such as CuI, INTO (indium tin oxide), SnO₂, ZnO, and In-Zn-O. The anode is formed by depositing the electrode material into a thin film by a vapor deposition method and a sputtering method. When allowing the emitted light from the light-emitting layer to pass through the anode, the transmittance of the anode to the emitted light is preferably 10% or more. The sheet resistance of the anode is preferably several hundreds Ω/square or less. The thickness of the anode varies depending upon the kind of material and generally 10 nm to 1 µm, preferably 50 to 200 nm.

The cathode is made from an electrode material having a small work function (4 eV or less), for example, an alloy, an electron-conductive compound and mixtures thereof. Examples of the electrode material for cathode include sodium, sodium-potassium allow, magnesium, lithium, magnesium silver alloy, aluminum/aluminum oxide, Al/Li₂O, Al/LiO₂, Al/LIF, aluminum lithium alloy, indium, and rare earth metal. The cathode is formed by depositing the electrode material into a thin film by a vapor deposition method and a sputtering method. When allowing the emitted light from the organic compound layer to pass through the cathode, the transmittance of the cathode to the emitted light is preferably 10% or more. The sheet resistance of the cathode is preferably several hundreds Ω/square or less. The thickness of the cathode is generally 10 nm to 1 µm and preferably 50 to 200 nm.

In the organic EL device of the invention, it is preferred to dispose at least one layer selected from a chalcogenide layer, a metal halide layer and a metal oxide layer (hereinafter may be referred to as "surface layer") on the surface of at least one of the pair of electrodes. For example, a layer of chalcogenide (inclusive of oxide) of metal such as silicon and aluminum is disposed on the surface of anode which faces the organic compound layer, and a metal halide layer or a metal oxide layer is disposed on the surface of cathode which faces the organic compound layer. With such a surface layer, the organic EL device is driven stably. Preferred examples of the chalcogenide include SiOx (1≤x≤2), AlOx (1 ≤ x ≤ 1.5), SiON, and SiAlON; preferred examples of the metal halide include LIF, MgF₂, CaF₂, and rare earth metal fluoride; and preferred examples of the metal oxide include Cs₂O, Li₂O, MgO, SrO, BaO, and CaO.

In the organic EL device of the invention, it is also preferable to dispose a mixed region of an electron transferring compound and a reductive dopant or a mixed region of a hole transferring compound and an oxidative dopant on the surface of at least one of the pair of electrodes. With such a mixed region, the electron transporting compound is reduced into anions to facilitate the injection and transfer of electrons into the emission medium from the mixed region. Alternatively, the hole transferring compound is oxidized to cations to facilitate the injection and transfer of holes into the emission medium from the mixed region. Preferred examples of the oxidative dopant include Lewis acids and acceptor compound. Preferred examples of the reductive dopant include alkali metals, alkali metal compounds, alkaline earth metals, rare earth metals and compounds thereof.

In the organic EL device of the invention, the light-emitting layer has the following functions:
(i) Injection function: function of injecting holes from the anode or hole injecting layer, and injecting electrons from the cathode or electron injecting layer, due to the action of electric field;
(ii) Transporting function: function of transporting the injected charges (holes and electrons) by the force of electric field; and
(iii) Emission function: function of providing a zone for recombination of electrons and holes to cause the emission.

The layer (the organic compound layer, particularly the light-emitting layer) containing the polymer of the invention is formed, for example, by masking a solution of the polymer into a film. Examples of the film-forming method include a spin coating method, a casting method, a microgravure coating method, a gravure coating method, a bar coating method, a roll coating method, a wire bar coating method, a dip coating method, a spray coating method, a screen printing method, a flexographic printing method, an off-set printing method, and an ink-jet printing method, with the screen printing method, flexographic printing method, off-set printing method, and ink-jet printing method being preferred because of their easiness of pattern formation. Since the film formation by these methods can be made under the conditions well known by a skilled person, the details thereof are omitted here for conciseness.

It is sufficient for the film-forming solution to contain at least one kind of polymer of the invention. In addition to the polymer, the film-forming solution may contain a hole transporting material, an electron transporting material, a light-emitting material, a solvent, and an additive such as a stabilizer. The content of the polymer in the film-forming solution is preferably 20 to 100% by weight and more preferably 40 to 100% by weight based on the total amount of the dissolved components other than the solvent. The amount of the solvent is preferably 1 to 99.9% by weight and more preferably 80 to 99% by weight based on the film-forming solution.

The film-forming solution may contain an additive for controlling the viscosity and/or surface tension, for example, a thickener (polymers, poor solvents of the polymer of the invention, etc.), a viscosity depressant (low molecular compounds, etc.) and a surfactant. In addition, an antioxidant not adversely affecting the performance of the organic EL device, for example, a phenol antioxidant and a phosphine antioxidant, may be included so as to improve the storage stability.

Examples of the solvent for the film-forming solution include a chlorine-containing solvent such as chloroform, methylene chlorine, 1,2-dichloroethane, 1,1,2-trichloroethane, chlorobenzene, and o-dichlorobenzene; an ether solvent such as tetrahydrofuran, dioxane, and anisole; an aromatic hydrocarbon solvent such as toluene and xylene, an aliphatic hydrocarbon solvent such as cyclohexane, methylcyclohexane, n-pentane, n-hexane, n-heptane, n-octane, n-nonane, and n-decane; a ketone solvent such as acetone, methyl ethyl ketone, cyclohexanone, benzophenone, and acetophenone; an ester solvent such as ethyl acetate, butyl acetate, ethyl cellosolve acetate, methyl benzoate, and phenyl acetate, a polyhydric alcohol and its derivatives such as ethylene glycol, ethylene glycol monobutyl ether, ethylene glycol monoethyl ether, ethylene glycol monoethyl ether, dimethoxyethane, propylene glycol, diethoxymethane, triethylene glycol monoethyl ether, glycerin, and 1,2-hexanediol; an alcoholic solvent such as methanol, ethanol, propanol, isopropanol, and cyclohexanol; a sulfoxide solvent such as dimethyl sulfoxide; and an amide solvent such as N'-methyl-2-pyrrolidone and N,N-dimethylformamide. These organic solvents may be used alone or in combination of two or more. Of the above solvents, in view of solubility, uniform film formation, viscosity, etc., preferred are the aromatic hydrocarbon solvent, the ether solvent, the aliphatic hydrocarbon solvent, the ester solvent and the ketone solvent, and more preferred are toluene, xylene, ethylbenzene, diethylbenzene, trimethylbenzene, n-propylbenzene, isopropylbenzene, n-butylbenzene, isobutylbenzene, 5-butylbenzene, n-hexylbenzene, cyclohexylbenzene, 1-methylnaphthalene, tetralin, anisole, ethoxybenzene, cyclohexane, bicyclohexyl, cyclohexenylcyclohexanone, n-heptylcycbhexane, n-hexylcyclohexane, decalin, methyl benzoate, cyclohexanone, 2-propylcyclohexanone, 2-heptanone, 3-heptanone, 4-heptanone, 2-octanone, 2-nonanone, 2-decanone, dicyclohexyl ketone, acetophenone, and benzophenone.

The light-emitting layer may contain an organic compound other than the polymer, and another light-emitting layer containing a known organic compound may be laminated onto the light-emitting layer containing the polymer, if necessary, as long as the object of the invention is not adversely affected.

For example, the light-emitting layer may contain, in addition to the polymer, at least one compound selected from a compound represented by formula (1), a homopolymer composed of the repeating units A, a copolymer having the repeating units A, a compound represented by any of formulae (2) to (9), a homopolymer composed of the repeating units B, and a copolymer having the repeating units B.

The light-emitting layed may contain a known fluorescent or phosphorescent dopant in an amount of 0.1 to 20 parts by weight per 100 parts by weight of the polymer, because the luminance and the emission efficiency are further improved. The fluorescent dopant may be selected from amine compound, chelate complex such as tris(8-quinolinolato)aiuminum, coumarin derivative, tetraphenylbutadiene derivative, and oxadiazole derivative according to the desired emission color. The phosphorescent dopant is preferably a metal complex comprising a metal selected from Ir, Ru, Pd, Pt, Os and Re, and the ligand thereof has preferably at least one skeletal structure selected from phenylpyridine, bipyridyl and phenanthroline. Examples of the metal complex include tris(2-phenylpyridine)iridium, tris(2-phenylpyridine)ruthenium, tris(2-phenylpyridine)palladium, bis(2-phenylpyridine)plainum, tris(2-phenylpyridine)osmium, tris(2-phenylpyridine)rhenium, octaethylplatinum porphyrin, octaphenylplatinum porphyrin, octaethylpalladium porphyrin, and octaphenylpalladium porphyrin. The metal complex is not particularly limited to those mentioned above and suitably selected according to the emission color, device performance and relation to the polymer each being desired.

The light-emitting layer may contain an arylamine compound and/or a styrylamine compound in an amount of 0.1 to 50 parts by weight based on 100 parts by weight of the polymer, because the luminance and the emission efficiency are further improved. Examples of the arylamine compound are described in, for example, WO 02/20459, JP 2006-140235A, JP 2006-306745A, WO 2004/09211, WO 2004/044088, JP 2006-256979A, JP 2007-230960A, WO 2004/088162, JP 2006-298793A, WO 02/20460, WO 02/20460, JP 2007-137824A, JP 2007-45725A, and JP 2005-068087A. Examples of the styrylamine compound are described in, for example, WO 02/20459.

The light-emitting layer may contain the metal complex in an amount of 0.1 to 50 parts by weight based on 100 parts by weight of the polymer, because the luminance and the emission efficiency are further improved.

The hole injecting/transporting layer is a layer for facilitating the injection of holes into the light-emitting layer and transporting holes to the emission region and has a large hole mobility and an ionization potential generally as small as 55 eV or less. A material capable of transporting holes to the light-emitting layer even under a lower electric field strength, for example, a material having a hole mobility of at least 10⁻⁶ cm²/Vs at an electric field strength of 10⁴ to 10⁶ V/cm is preferably used for forming the hole injecting/transporting layer. The material is arbitrarily selected from known hole transporting materials commonly used as photoconductive materials and known materials commonly used for the hole injecting layer of organic EL device. The hole injecting/transporting layer is formed by depositing a hole injecting/transporting material in a thin film, for example, by a vacuum vapor deposition method, a spin coating method, a casting method or LB method. The thickness of the hole injecting/transporting layer is generally 5 nm to 5 µm, although not particularly limited thereto.

The electron injecting/transporting layer is a layer for facilitating the injection of electrons into the light-emitting layer and transporting electrons to the emission region and has a large electron mobility. The adhesion improving layer is an electron injecting layer particularly made of a material having a good adhesion to the cathode. As the material for the electron injecting layer, a metal complex of 8-hydroxyquinoline or its derivative are suitably used. Examples of the metal complex of 8-hydroxyquinoline or its derivative include metal chelated oxinoid compound having a chelating ligand of oxine (generally referred to as 8-quinolinol or 8-hydroxyquinoline), for example, tris(8-quinonnol)aluminum. Since the electric filed exerts its influence on the ultrathin films of the organic EL device of the invention, the pixel defect due to leakage and short circuit is likely to cause. To prevent this, an insulating thin-film layer may be disposed between a pair of electrodes.

Examples of the material for forming the insulating layer include aluminum oxide, lithium fluoride, lithium oxide, cesium fluoride, cesium oxide, magnesium oxide, magnesium fluoride, calcium oxide, calcium fluoride, aluminum nitride, titanium oxide, silicon oxide, germanium oxide, silicon nitride, boron nitride, molybdenum oxide, ruthenium oxide, and vanadium oxide. A mixture thereof is also usable. The insulating layer may be a laminate of layers of these materials.

As described above, the organic EL device of the invention is produced, for example, by forming the anode, the light-emitting layer, the optional hole injecting layer, the optional electron injecting layer, and finally the cathode by the method using the above materials each mentioned above. Alternatively, the organic EL device may be produced in the reverse order from the cathode to the anode.

### EXAMPLES

The present invention is explained below in more detail with reference to the examples. However, it should be noted that the scope of the invention is not limited to the following examples.

### EXAMPLE 1

### (1) Synthesis of monomer

Intermediate a (Monomer 1) was synthesized by a common method with reference to JP 2007-284491A and other documents.

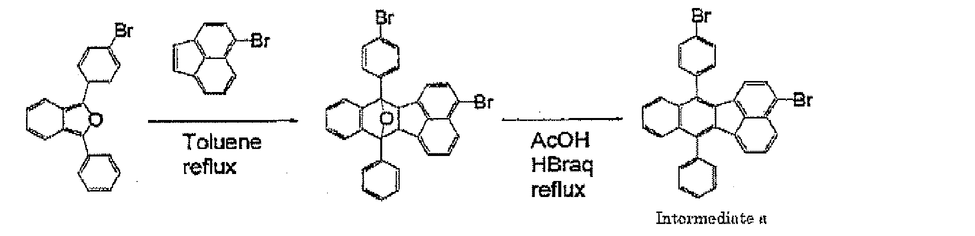

Intermediate b (Monomer 2) was synthesized by a common method according to the following reaction scheme.

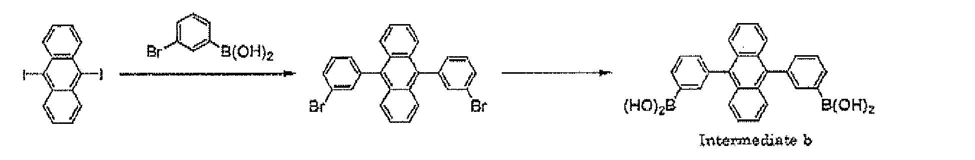

### (2) Synthesis of polymer

In a 300-mlthree-necked flask equipped with a cooling column, 0.135 g (0.24 mmol) of Intermediate a (Monomer 1),1.08 g (3.76 mmol) of 2,6-dibromonaphthalene (Monomer 2),1.66 g (3.96 mmol) of Intermediate b (Monomer 3), 2.7 mg of palladium acetate, 29.6 mg of tris(2-methoxyphenyl)phosphine, Aliquat 336 (0.52 g, manufactured by Aldrich Chemical Co., Inc.), and 40 ml of dry toluene were mixed under argon atmosphere. The mixture was heated to 105 °C. The resulting reaction liquid was added dropwise with a 2 M Na₂CO₃ aqueous solution (10.9 ml) and refluxed for 8 h.
After the reaction, 50 mg of phenyl borate was added and the reflux was continued for 2 h to allow the reaction to proceed. After adding an aqueous solution of sodium diethyldithiacarbamate, the mixture was stirred at 80 °C for 2 h. After cooling, the mixture was extracted with an organic solvent and then the extract was concentrated. The precipitate was collected by filtration and successively washed with ion-exchanged water, a 3% aqueous solution of acetic acid, ion-exchanged water, and methanol. The washed precipitate was dissolved in toluene under heating and purified by passing through a silica gel column. The obtained toluene solution was concentrated and then added dropwise to a methanol solution for reprecipitation. The precipitate was collected by filtration and dried to obtain Polymer 1 (1.98 g).
The molecular weights of Polymer 1 were Mn = 13,500 and Mw = 31,500 (standard polystyrene calibration).
On a glass substrate having a 150-nm thick ITO sputtered film, PEDOT/PSS aqueous solution (Bayton P available from Bayer Aktiengesellschaft) was spin-coated to form a film of 50 nm thick and dried at 200 °C for 10 min on a hot plate. Then, a 1.2 wt% xylene solution of Polymer 1 was spin-coated at 900 rpm to form a film of about 100 nm thick, dried at 130 °C for 1 h in argon atmosphere, and then vacuum dried. Thereafter, Alq was vapor-deposited to form an electron transporting layer of 20 nm thick, and lithium fluoride was vapor deposited to a thickness of about 1 nm and then aluminum to a thickness of about 150 nm to form a cathode, thereby producing an organic EL device.
The device characteristics of the obtained device are shown in Table 1.

### EXAMPLES 2-7 and COMPARATIVE EXAMPLE 1

Each polymer was synthesized in the same manner as in Example 1 except for using the monomers listed in Table 1. The monomers used in Examples 2-7 were synthesized by a common method according to the following reaction schemes. The polymer used in Comparative Example 1 was synthesized according to the method in JP 2007-162009A.

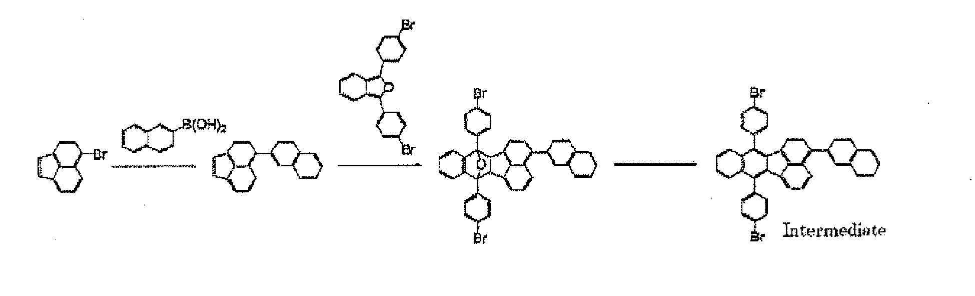

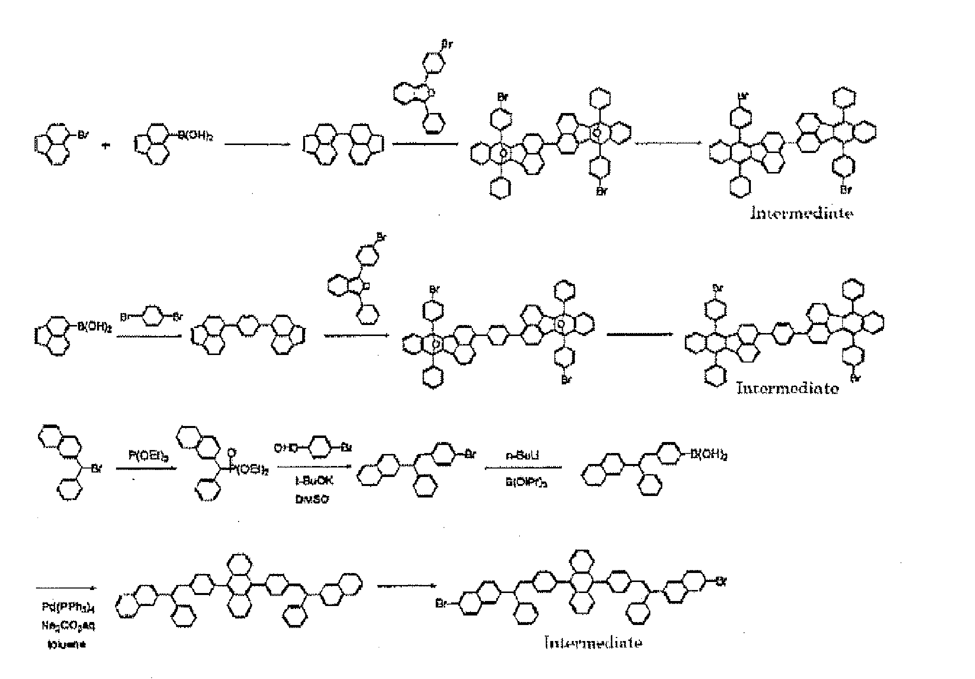

**Table 1**

| | Monomer 1 | Monomer 2 | Monomer 3 |
|---|---|---|---|
| Examples | | | |
| 1 | 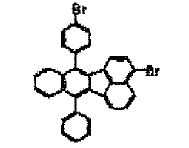 | 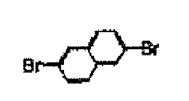 | 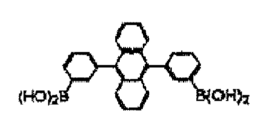 |
| 2 | 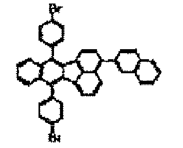 | 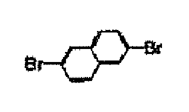 | 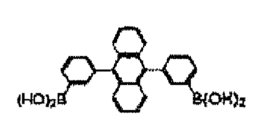 |
| 3 | 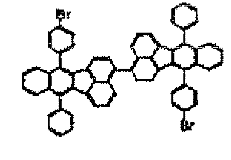 | 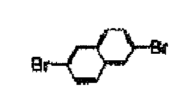 | 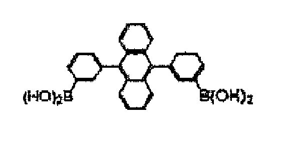 |
| 4 | 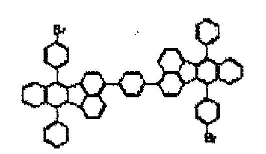 | 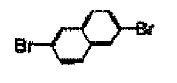 | 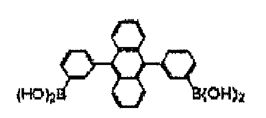 |
| 5 | 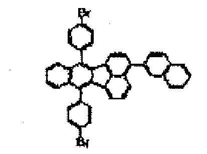 | 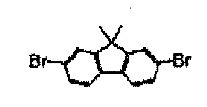 | 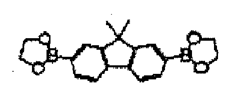 |
| 6 | 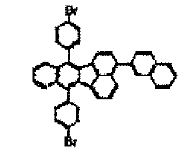 | 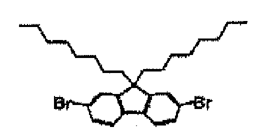 | 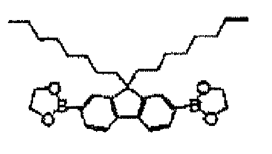 |
| 7 | 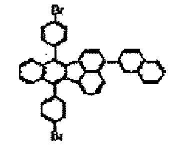 | 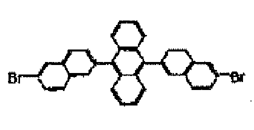 | 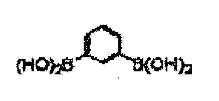 |
| 8 | 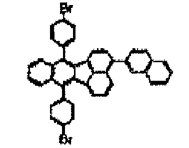 | 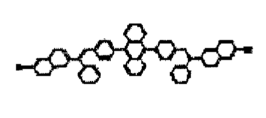 | 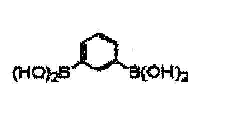 |

| Comparative Example | | | |
|---|---|---|---|
| 1 | 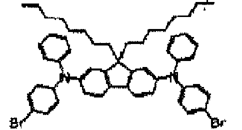 | 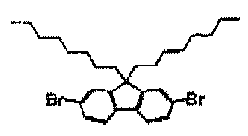 | 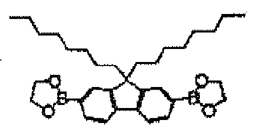 |

| Table 1 (contd.) | | | | | | |
|---|---|---|---|---|---|---|
| | Mn | Mw | Emission color | Peak wavelength (nm) | Maximum efficiency (cd/A) | Half lifetime (@ 1000 nit) |
| Examples | | | | | | |
| 1 | 13,500 | 31,500 | blue | 440 | 4.1 | 230 |
| 2 | 15,000 | 33,000 | blue | 445 | 4.2 | 215 |
| 3 | 24,500 | 56,000 | blue | 458 | 3.8 | 210 |
| 4 | 23,300 | 55,900 | blue | 460 | 3.7 | 250 |
| 5 | 26,800 | 61,500 | blue | 445 | 4.3 | 195 |
| 6 | 31,500 | 72,300 | blue | 445 | 4.2 | 180 |
| 7 | 19,000 | 45,000 | blue | 445 | 4.2 | 230 |
| 8 | 23,000 | 55,200 | blue | 450 | 4.3 | 180 |

| Comparative Example | | | | | | |
|---|---|---|---|---|---|---|
| 1 | 17,500 | 40,000 | blue | 460 | 2.9 | 5 |

## Claims

1. A polymer comprising a repeating unit A and a repeating unit B, wherein the repeating unit A is selected from divalent groups which are derived from compounds represented by formula (1): 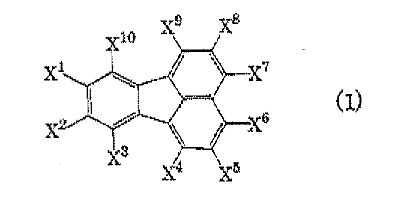 wherein X¹ to X¹⁰ are each independently hydrogen atom, a halogen atom, an alkyl group having 1 to 30 carbon atoms, a cycloalkyl group having 3 to 30 ring-forming carbon atoms, an alkoxy group having 1 to 80 carbon atoms, a cycloalkyloxy group having 3 to 30 ring-forming carbon atoms, an alkylthio group having 1 to 30 carbon atoms, a cycloalkylthio group having 3 to 30 ring-forming carbon atoms, an alkenyl group having 2 to 30 carbon atoms, a cycloalkenyl group having 3 to 30 ring-forming carbon atoms, an alkenyloxy group having 2 to 30 carbon atoms, a cycloalkenyloxy group having 3 to 30 ring-forming carbon atoms, an alkenylthio group having 2 to 30 carbon atoms, a cyloalkenylthio group having 3 to 30 ring-forming carbon atoms, an aralkyl group having 7 to 30 carbon atoms, an aralkyloxy group having 7 to 30 carbon atoms, an aralkylthio group having 7 to 30 carbon atoms, an aryl group having 6 to 20 ring-forming carbon atoms, a heterocyclic group having 5 to 20 ring-forming carbon atoms, an aryloxy group having 6 to 20 ring-forming carbon atoms, an arylthio group having 6 to 20 ring-forming carbon atoms, a mono- or disubstituted amino group having 1 to 30 carbon atoms, cyano group, silyl group, hydroxyl group, -COOR¹⁰ wherein R¹⁰ is hydrogen atom, an alkyl group having 1 to 30 carbon atoms, a cycloalkyl group having 3 to 30 ring-forming carbon atoms, an alkenyl group having 2 to 30 carbon atoms, a cycloalkenyl group having 3 to 30 ring-forming carbon atoms, an aralkyl group having 7 to 30 carbon atoms, or an aryl group having 6 to 30 ring-forming carbon atoms, -COR¹¹ wherein R¹¹ is hydrogen atom, an alkyl group having 1 to 30 carbon atoms, a cycloalkyl group halving 3 to 30 ring-forming carbon atoms, an alkenyl group having 2 to 30 carbon atoms, a cycloalkenyl group having 3 to 30 ring-forming carbon atoms, an aralkyl group having 7 to 30 carbon atoms, an aryl group having 6 to 30 ring-forming carbon atoms, or amino group, or -OCOR¹² wherein R¹² is an alkyl group having 1 to 30 carbon atoms, a cycloalkyl group having 3 to 30 ring-forming carbon atoms, an alkenyl group having 2 to 30 carbon atoms, a cycloalkenyl group having 3 to 30 ring-forming carbon atoms, an aralkyl group having 7 to 30 carbon atoms, or an aryl group having 6 to 30 ring-forming carbon atoms, each of the above groups being optionally substituted, if applicable, and adjacent groups of X¹ to X¹⁰ and substituents on adjacent groups s of X¹ to X¹⁰ being optionally bonded to each other to form a divalent group which completes a substituted or unsubstituted ring;
the repeating unit B is selected from divalent groups which are derived from compounds represented by any one of formulae (2) to (9): 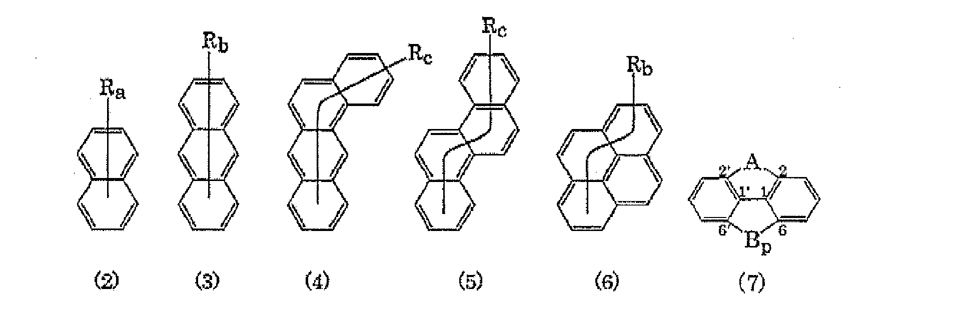 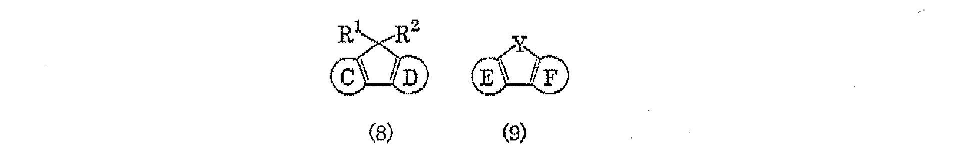 wherein, in formulae (2) to (6), R is a substituted or unsubstituted aryl group halving 6 to 40 ring-forming carbon atoms, a substituted or unsubstituted heterocyclic group having 3 to 40 ring-forming atoms, or a substituted or unsubstituted alkyl group having 1 to 50 carbon atoms; a is an integer of 0 to 6; b is an integer of 0 to 8; and c is an integer of 0 to 10;
in formula (7), A is a substituted or unsubstituted divalent saturated group which forms a 5- to 8-membered ring together with the carbon atoms at 1, 2, 1', and 2' positions or the biphenyl structure; B is a substituted or unsubstituted divalent saturated group which forms a 5- to 8-membered ring together with the carbon atoms at 1, 6, 1', and 6' positions of the biphenyl structure; A and B may be the same or different; p is 0 or 1 and no bond is formed between the carbon atoms at 6 and 6' positions when p is 0; and a ring structure formed by A and the carbon atoms at 1, 2, 1', and 2' positions and/or a ring structure formed by B and the carbon atoms at 1, 6, 1', and 6' positions may have a apiro-ring structure;
in formula (8), a ring C and a ring D are each independently an aromatic hydrocarbon ring having 6 to 40 ring-forming carbon atoms; at least one of the ring C and the ring D is an aromatic hydrocarbon ring comprising two or more condensed benzene rings; R¹ and R² are each independently hydrogen atom, an alkyl group having 1 to 30 carbon atoms, an alkoxy group having 1 to 30 carbon atoms, an alkylthio group having 1 to 30 carbon atoms, an aryl group having 6 to 20 ring-forming carbon atoms, an aryloxy group having 6 to 20 ring-forming carbon atoms, an arylthio group having 6 to 20 ring-forming carbon atoms, an aralkyl group having 7 to 30 carbon atoms, an aralkyloxy group having 7 to 30 carbon atoms, an aralkylthio group having 7 to 30 carbon atoms, an arylalkenyl group having 8 to 30 carbon atoms, an arylalkynyl group having 8 to 30 carbon atoms, amino group, a mono- or disubstituted amino group having 1 to 30 carbon atoms, silyl group, a mono-, di- or trisubstituted silyl group having 1 to 30 carbon atoms, a halogen atom, -COR¹¹ wherein R¹¹ is as defined above, -OCOR¹² wherein R¹² is as defined above, an imine residue having 2 to 30 carbon atoms, an amido group having 2 to 30 carbon atoms, an acid imido group having 3 to 30 carbon atoms, a heterocyclic group having 5 to 20 ring-forming carbon atoms, -COOR¹⁰ wherein R¹⁰ is as defined above, nitro group, or cyano group, and R¹ and R² may be bonded to each other to form a ring; and
in formula (9), a ring E and a ring F are each independently an aromatic hydrocarbon ring having 6 to 40 ring-forming carbon atoms; Y is oxygen atom, sulfur atom, or -O-C(R³)₂- wherein two R³ groups are each independently hydrogen atom, an alkyl group having 1 to 30 carbon atoms, an alkoxy group having 1 to 30 carbon atoms, an alkylthio group having 1 to 30 carbon atoms, an aryl group having 6 to 20 ring-forming carbon atoms, an aryloxy group having 6 to 20 ring-forming carbon atoms, an arylthio group having 6 to 20 ring-forming carbon atoms, an aralkyl group having 7 to 30 carbon atoms, an aralkyloxy group having 7 to 30 carbon atoms, an aralkylthio group having 7 to 30 carbon atoms, an arylalkenyl group having 8 to 30 carbon atoms, an arylalkynyl group having 8 to 30 carbon atoms, amino group, a mono- or disubstituted amino group having 1 to 30 carbon atoms, silyl group, a mono-, di- or trisubstituted silyl group having 1 to 30 carbon atoms, halogen atom, -COR¹¹ wherein R¹¹ is as defined above, -OCOR¹² wherein R¹² is as defined above, an imine residue having 2 to 30 carbon atoms, an amido group having 2 to 30 carbon atoms, an acid imido group having 3 to 30 carbon atoms, a heterocyclic group having 5 to 20 ring-forming carbon atoms, -COOR¹⁰ wherein R¹⁰ is as defined above, nitro group, or cyano group, and
two R³ groups may be the same or different.

2. The polymer according to claim 1, wherein the compound of formula (3)
is represented by 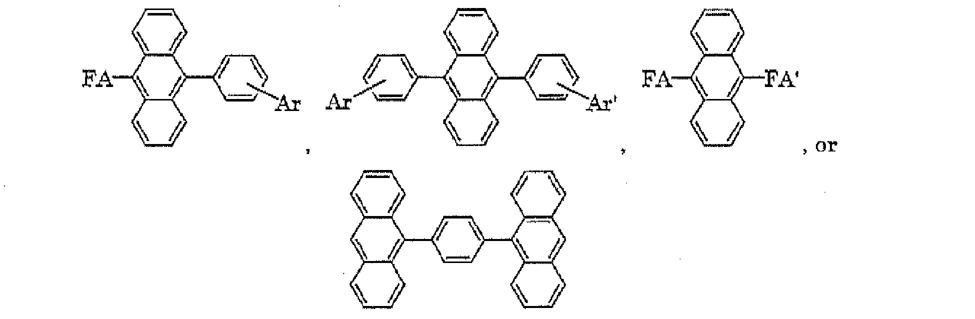 wherein FA and FA' are each independently a substituted or unsubstituted aryl group having 6 to 30 ring-forming carbon atoms and Ar and Ar' are each independently a substituted or unsubstituted aryl group having 6 to 40 ring-forming carbon atoms, a substituted or unsubstituted heterocyclic group having 3 to 40 ring-forming atoms, a substituted or unsubstituted benzyl group, or a substituted or unsubstituted alkyl group having 1 to 50 carbon atoms.

3. The polymer according to claim 1 or 2, wherein a content of the repeating unit A is 0.1 to 50 mol% based on the total of the repeating units.

4. An organic electroluminescent material comprising the polymer as defined in any one of claims 1 to 3.

5. The organic electroluminescent material according to claim 4, which further comprises a compound selected from the group consisting of a compound represented by formula (1) as defined in claim 1, a homopolymer comprising the repeating unit A as defined in claim 1, a copolymer comprising the repeating unit A, a compound represented by any one of formulae (2) to (9) as defined in claim 1, a homopolymer comprising the repeating unit B as defined in claim 1, and a copolymer comprising the repeating unit B.

6. An organic electroluminescence device comprising an anode, a cathode, and an organic compound layer which comprises a layer and is disposed between the anode and the cathode, wherein at least one layer of the organic compound layer is a light-emitting layer comprising the polymer as defined in claim 1.

7. The organic electroluminescence device according to claim 6, wherein the light-emitting layer further comprises a compound selected from the group consisting of a compound represented by formula (1) as defined in claim 1, a homopolymer comprising the repeating unit A as defined in claim 1, a copolymer comprising the repeating unit A, a compound represented by any one of formulae (2) to (9) as defined in claim 1, a homopolymer comprising the repeating unit B as defined in claim 1, and a copolymer comprising the repeating unit B.

8. The organic electroluminescence device according to claim 6 or 7,
wherein the light-emitting layer further comprises a phosphorescent dopant and/or a fluorescent dopant.

9. The organic electroluminescence device according to any one of claims 6 to 8, wherein the light-emitting layer further comprises an arylamine compound and/or a styrylamine compound.

10. The organic electroluminescence device according to any one of claims 6 to 9, wherein the light-emitting layer further comprises a metal complex.
